# EUROPEAN PATENT SPECIFICATION

(11) **EP 3 839 994 B1**
(45) Date of publication and mention of the grant of the patent: **05.07.2023**
(21) Application number: 20210010.3
(22) Date of filing: 26.11.2020
(51) Int. Cl.: H10K 85/30, H10K 85/60, H10K 30/40, H10K 85/50

(54) **PHOTOELECTRIC CONVERSION ELEMENT, PHOTOELECTRIC CONVERSION MODULE, ELECTRONIC DEVICE, AND POWER SUPPLY MODULE**
PHOTOELEKTRISCHES UMWANDLUNGSELEMENT, PHOTOELEKTRISCHES UMWANDLUNGSELEMENTMODUL, ELEKTRONISCHE VORRICHTUNG UND STROMVERSORGUNGSMODUL
ÉLÉMENT DE CONVERSION PHOTOÉLECTRIQUE, MODULE DE CONVERSION PHOTOÉLECTRIQUE, DISPOSITIF ÉLECTRONIQUE ET MODULE D'ALIMENTATION ÉLECTRIQUE

(30) Priority: 28.11.2019 JP 2019215216
(43) Date of publication of application: 23.06.2021
(73) Proprietor: Ricoh Company, Ltd., Tokyo 143-8555 (JP)
(72) Inventor: HORIUCHI, Tamotsu, Tokyo, 143-8555 (JP); IDE, Takahiro, Tokyo, 143-8555 (JP); TANAKA, Yuuji, Tokyo, 143-8555 (JP); TAMOTO, Nozomu, Tokyo, 143-8555 (JP); KANEI, Naomichi, Tokyo, 143-8555 (JP); SHIBA, Masana, Tokyo, 143-8555 (JP)
(74) Representative: J A Kemp LLP

(56) References cited:
- EP-A1- 3 133 664
- WO-A1-2019/181330
- US-A1- 2019 237 598

## Description

### BACKGROUND OF THE INVENTION

### Field of the Invention

The present disclosure relates to a photoelectric conversion element, a photoelectric conversion module, an electronic device, and a power supply module.

### Description of the Related Art

In recent years, solar cells using a photoelectric conversion element have been expected to be widely applied not only in terms of alternative to fossil fuels and measures against global warming but also as self-supporting power supplies that require neither replacement of a cell nor power source wirings. The solar cells as the self-supporting power supplies attract much attention as one of energy harvesting techniques required in, for example, Internet of Things (IoT) devices and artificial satellites.

Examples of the solar cells include organic solar cells such as dye-sensitized solar cells, organic thin film solar cells, and perovskite solar cells, in addition to inorganic solar cells using silicon etc. that have been widely conventionally used.

The perovskite solar cells are advantageous in terms of improvement of safety and reduction in production cost because they do not use an electrolyte containing, for example an organic solvent and can be produced by a conventional printing unit.

Regarding the perovskite solar cell, the technique of inclusion of Spiro and Li-TFSI in a hole-transporting layer has been known. However, the technique has a problem that durability to high temperature and high humidity is deteriorated. Therefore, it has been known that an organic semiconductor component and a halogen-containing polymer that has a structure in which an electron attractive group is bound to a heteroatom are included to solve the aforementioned problem (see, for example, Japanese Unexamined Patent Application Publication No. 2018-082135).

An object of the present disclosure is to provide a photoelectric conversion element that can maintain photoelectric conversion efficiency even after exposure to light of high illuminance for a long period of time.

US 2019/237598 A1, EP 3 133 644 A1 and WO 2019/181330 A1 disclose background art to the invention.

### SUMMARY OF THE INVENTION

According to one aspect of the present disclosure, a photoelectric conversion element includes: a first electrode; a perovskite layer; a hole-transporting layer; and a second electrode. The hole-transporting layer includes a compound represented by General Formula (1) below or General Formula (1a) below.

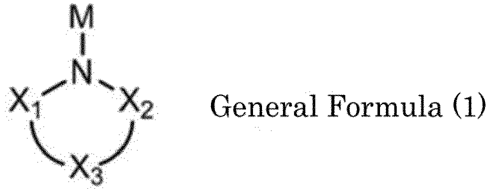

In the General Formula (1), M represents an alkali metal. X₁ and X₂, which may be identical to or different from each other, each represent at least one selected from the group consisting of a carbonyl group, a sulphonyl group, and a sulfinyl group. X₃ represents at least one selected from the group consisting of a bivalent alkyl group, an alkenyl group, and an aryl group. A hydrogen atom of the bivalent alkyl group, the alkenyl group, and the aryl group may be substituted with a halogen atom.

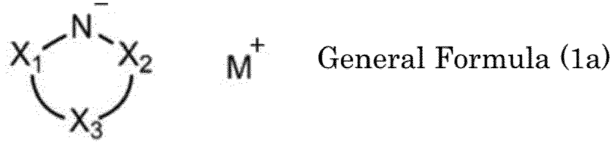

In the General Formula (1a), M⁺ represents an organic cation. X₁, X₂, and X₃ have the same meanings as X₁, X₂, and X₃ in the General Formula (1).

According to the present disclosure, it is possible to provide a photoelectric conversion element that can maintain photoelectric conversion efficiency even after exposure to light of high illuminance for a long period of time.

### BRIEF DESCRIPTION OF THE DRAWINGS

FIG. 1 is an explanatory view presenting one example of a structure in a photoelectric conversion module of the present disclosure;
FIG. 2 is an explanatory view presenting another example of a structure in a photoelectric conversion module of the present disclosure;
FIG. 3 is an explanatory view presenting another example of a structure in a photoelectric conversion module of the present disclosure;
FIG. 4 is an explanatory view presenting another example of a structure in a photoelectric conversion module of the present disclosure;
FIG. 5 is an explanatory view presenting another example of a structure in a photoelectric conversion module of the present disclosure;
FIG. 6 is an explanatory view presenting another example of a structure in a photoelectric conversion module of the present disclosure;
FIG. 7 is an explanatory view presenting another example of a structure in a photoelectric conversion module of the present disclosure;
FIG. 8 is a block diagram of a mouse for a personal computer as one example of an electronic device of the present disclosure;
FIG. 9 is a schematic external view presenting one example of the mouse presented in FIG. 8;
FIG. 10 is a block diagram of a keyboard for a personal computer as one example of an electronic device of the present disclosure;
FIG. 11 is a schematic external view presenting one example of the keyboard presented in FIG. 10;
FIG. 12 is a schematic external view presenting another example of the keyboard presented in FIG. 10;
FIG. 13 is a block diagram of a sensor as one example of an electronic device of the present disclosure;
FIG. 14 is a block diagram of a turntable as one example of an electronic device of the present disclosure;
FIG. 15 is a block diagram presenting one example of an electronic device of the present disclosure;
FIG. 16 is a block diagram presenting one example where a power supply IC is further incorporated into the electronic device presented in FIG. 15;
FIG. 17 is a block diagram presenting one example where an electricity storage device is further incorporated into the electronic device presented in FIG. 16;
FIG. 18 is a block diagram presenting one example of a power supply module of the present disclosure; and
FIG. 19 is a block diagram presenting one example where an electricity storage device is further incorporated into the power supply module presented in FIG. 18.

### DETAILED DESCRIPTION OF THE INVENTION

### (Photoelectric conversion element)

A photoelectric conversion element means an element that can convert light energy into electric energy, and is applied to, for example, a solar cell or a photodiode.

The photoelectric conversion element of the present disclosure includes a first electrode, a perovskite layer, a hole-transporting layer, and a second electrode, and further includes other members if necessary.

In the photoelectric conversion element of the present disclosure, the hole-transporting layer includes a compound represented by General Formula (1) below or General Formula (1a) below.

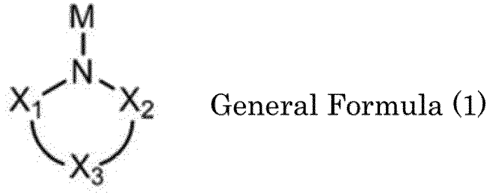

In the General Formula (1), M represents an alkali metal; X₁ and X₂, which may be identical to or different from each other, each represent at least one selected from the group consisting of a carbonyl group, a sulphonyl group, and a sulfinyl group; and X₃ represents at least one selected from the group consisting of a bivalent alkyl group, an alkenyl group, and an aryl group, a hydrogen atom of the bivalent alkyl group, the alkenyl group, and the aryl group may be substituted with a halogen atom.

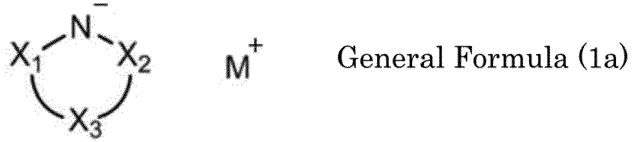

In the General Formula (1a), M⁺ represents an organic cation; and X₁, X₂, and X₃ have the same meanings as X₁, X₂, and X₃ in the General Formula (1).

The photoelectric conversion element of the present disclosure is based on the finding that a conventional photoelectric conversion element has problems that the photoelectric conversion efficiency is decreased in photoelectric conversion efficiency to deteriorate power generation performances when it is exposed to light of low illuminance after being exposed to light of high illuminance for a while.

The present inventors found that inclusion of a compound represented by the General Formula (1) or the General Formula (1a) in the hole-transporting layer can maintain high photoelectric conversion efficiency even when the photoelectric conversion element is exposed under an environment of high illuminance for a predetermined time and is exposed to light of low illuminance.

Note that, the photoelectric conversion efficiency may be simply referred to as "conversion efficiency" hereinafter.

Next, details of the respective layers including the hole-transporting layer in the photoelectric conversion element of the present disclosure will be described.

### <Hole-transporting layer>

The hole-transporting layer means a layer that transports holes generated in a perovskite layer to a second electrode that will be described hereinafter. Therefore, the hole-transporting layer is preferably disposed adjacent to the perovskite layer.

The hole-transporting layer in the photoelectric conversion element of the present disclosure includes a compound represented by the General Formula (1) or the General Formula (1a), and further includes other materials if necessary.

Examples of the alkali metal represented by M in the General Formula (1) include lithium, sodium, potassium, and cesium.

X₁ and X₂, which may be identical to or different from each other, each represent at least one selected from the group consisting of a carbonyl group, a sulphonyl group, and a sulfinyl group (-SO-).

X₃ represents at least one selected from the group consisting of a bivalent alkyl group, an alkenyl group, and an aryl group, a hydrogen atom of the bivalent alkyl group, the alkenyl group, and the aryl group may be substituted with a halogen atom.

Examples of the bivalent alkyl group include a bivalent methyl group, a bivalent ethyl group, a bivalent propyl group, and a bivalent butyl group.

Examples of the alkenyl group include a vinyl group.

Examples of the aryl group include a phenyl group and a 1-naphthyl group.

Examples of the organic cation represented by M⁺ in the General Formula (1a) include: nitrogen-containing organic cations such as imidazolium-based cations, pyrrolidinium-based cations, piperidinium-based cations, and aliphatic quaternary ammonium-based cations; phosphorous-containing organic cations such as tetramethylphosphonium cations, tetraethylphosphonium cations, tetrapropylphosphonium cations, tetrabutylphosphonium cations, tetraoctylphosphonium cations, trimethylethylphosphonium cations, triethylmethylphosphonium cations, hexyltrimethylphosphonium cations, and phosphonium cations (e.g., trimethyloctylphosphonium, triethyl(methoxymethyl)phosphonium, and triethyl(methoxymethyl)phosphonium); sulfur-containing organic cations such as trimethylsulfonium cations, triethylsulfonium cations, tributylsulfonium cations, diethylmethylsulfonium cations, dimethylpropylsulfonium, and dimethylhexylsulfonium; and oxonium cations.

A compound represented by the General Formula (1) is preferably a compound represented by the following General Formula (2) where X₁ and X₂ are each a sulphonyl group. A compound represented by the General Formula (1a) is preferably a compound represented by the following General Formula (2a) where X₁ and X₂ are each a sulphonyl group. Use of a strong attractive group (e.g., a sulphonyl group) as X₁ and X₂ is advantageous because electronegativity on a nitrogen atom becomes strong to obtain a higher anionic property.

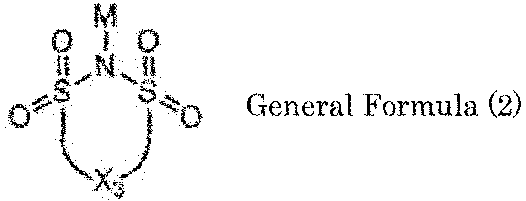

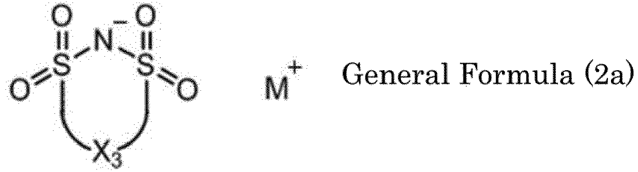

In the General Formulas (2) and (2a), X₃, M, and M⁺ have the same meanings as X₃, M, and M⁺ in the General Formulas (1) and (1a).

More preferably, in the General Formula (2), M is lithium, and X₃ is a bivalent alkyl group having from 2 through 4 carbon atoms that may include a fluorine atom as a substituent. When M is lithium and X₃ is a bivalent alkyl group having from 2 through 4 carbon atoms that may include a fluorine atom as a substituent in the General Formula (2), the short circuit current density becomes comparatively higher, and photoelectric conversion efficiency can be maintained even after exposure to light of high illuminance for a long period of time, which is advantageous.

Examples of the compound represented by the General Formula (1) include the following (A-1) to (A-72).

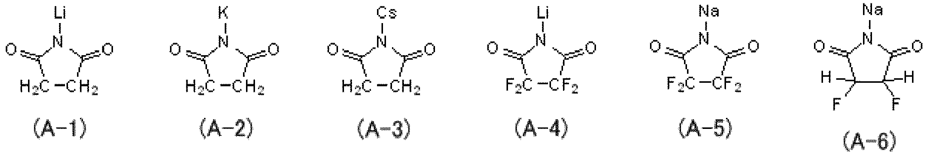

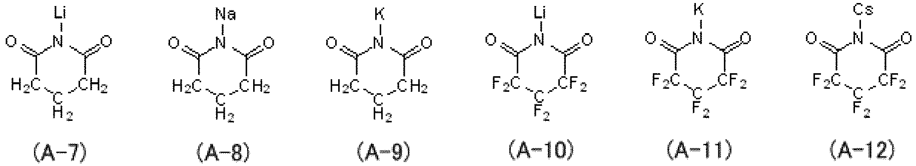

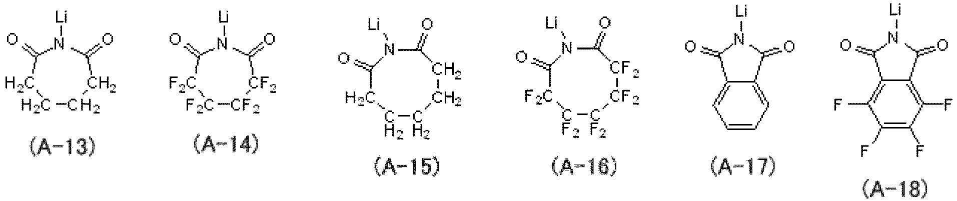

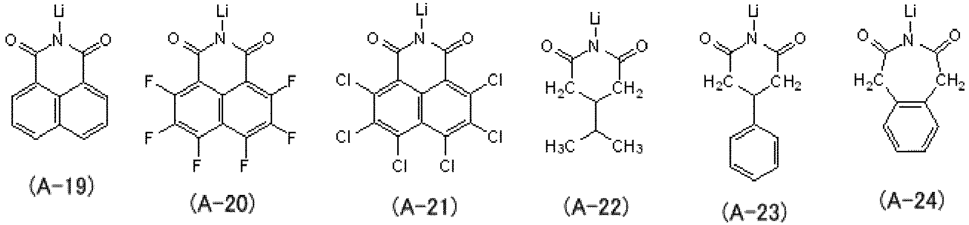

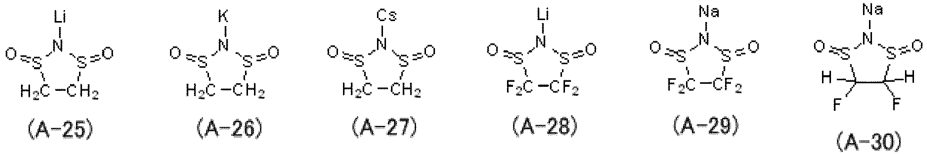

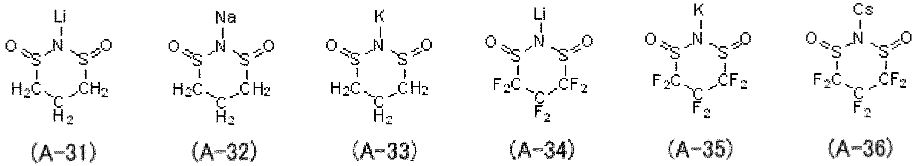

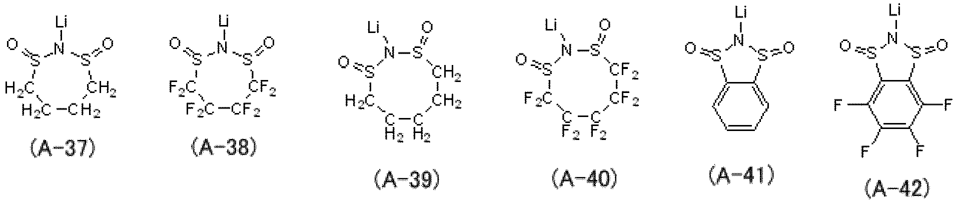

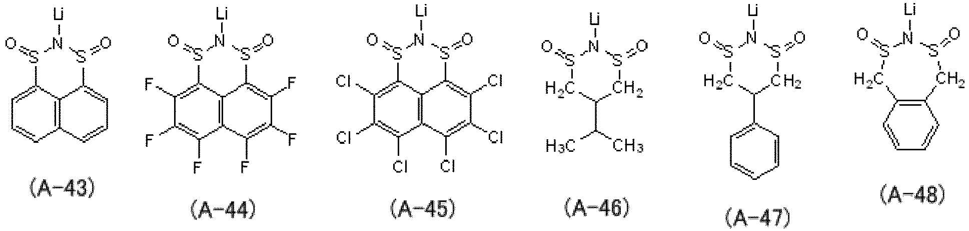

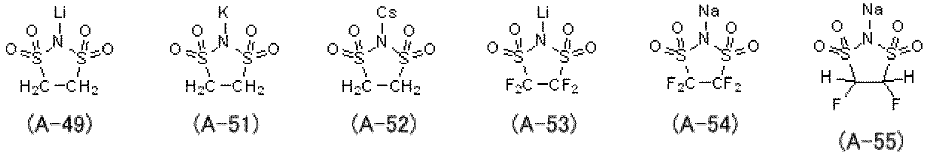

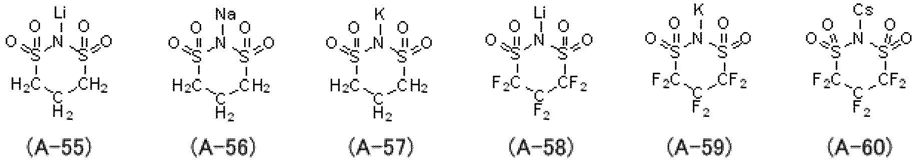

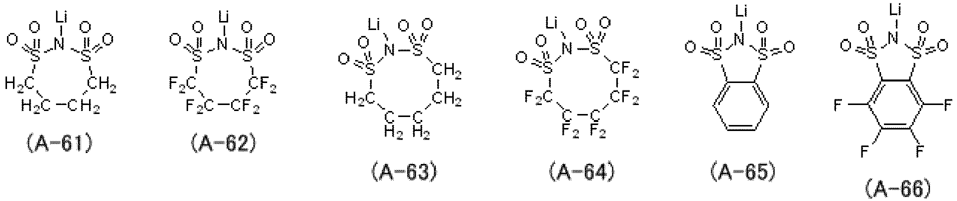

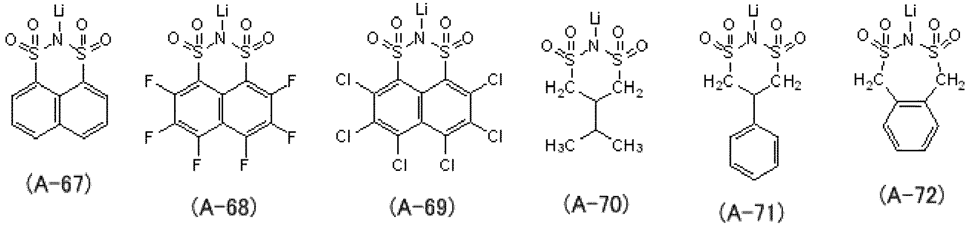

Examples of the compound represented by the General Formula (1a) include (A-73) to (A-86) and (C-87) to (C-94) exemplified below.

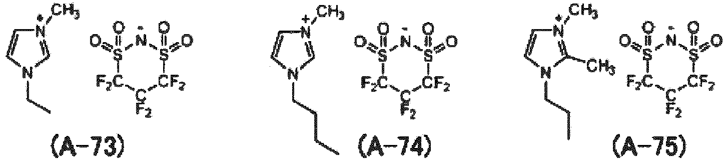

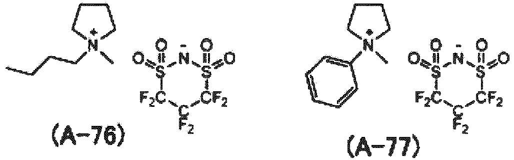

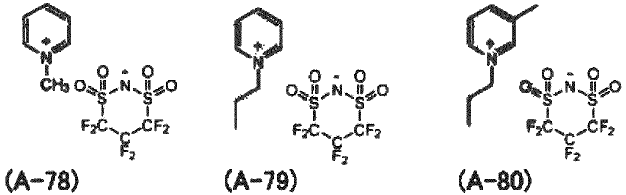

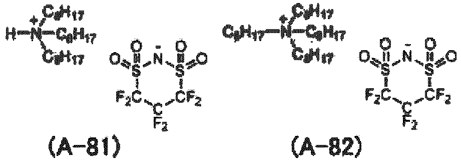

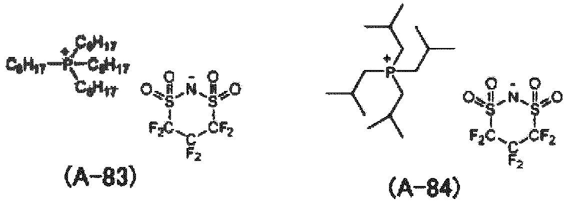

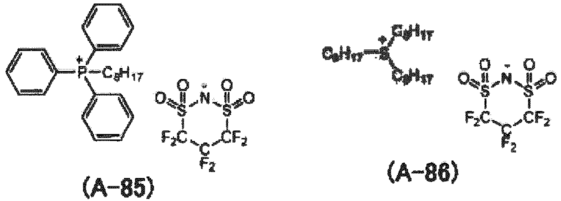

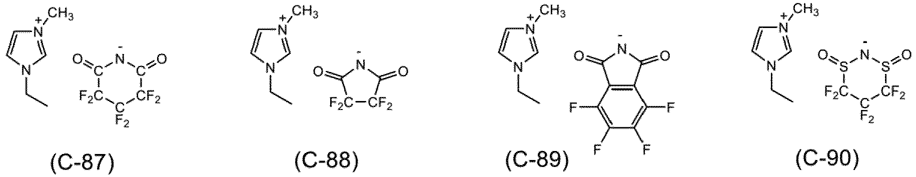

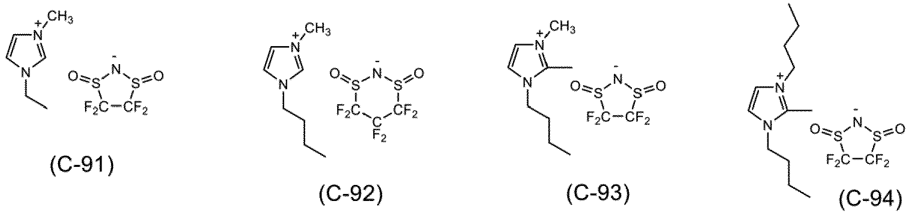

Preferably, the hole-transporting layer further includes a compound represented by the following General Formula (3) or the following General Formula (4). Further inclusion of a compound represented by the following General Formula (3) or the following General Formula (4) in the hole-transporting layer is advantageous in terms of adhesiveness to a counter electrode.

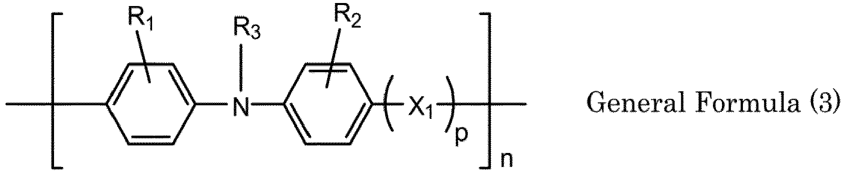

In the General Formula (3), R₁ and R₂, which may be identical to or different from each other, each represent at least one selected from the group consisting of a hydrogen atom, an alkyl group, an aralkyl group, an alkoxy group, and an aryl group.

Examples of the alkyl group include a methyl group, an ethyl group, and a 2-isobutyl group.

Examples of the aralkyl group include a benzil group and a 2-naphthylmethyl group.

Examples of the alkoxy group include a methoxy group and an ethoxy group. Examples of the aryl group include a phenyl group and a 1-naphthyl group.

R₃ represents one selected from the group consisting of an alkyl group, an aralkyl group, an aryl group, and a heterocyclic group.

Examples of the alkyl group include a methyl group, an ethyl group, and a 2-isobutyl group.

Examples of the aralkyl group include a benzil group and a 2-naphthylmethyl group.

Examples of the aryl group include a phenyl group and a 1-naphthyl group.

Examples of the heterocyclic group include a thiophene ring group and a furan ring group.

X₁ represents at least one selected from the group consisting of an alkylene group, an alkenyl group, an alkynyl group, an aryl group, and a heterocyclic group.

Examples of the alkylene group include a methylene group, an ethylene group, a propylene group, a butylene group, and a hexylene group.

Examples of the alkenyl group include a vinyl group.

Examples of the alkynyl group include acetylene.

Examples of the aryl group include a phenyl group and a 1-naphthyl group.

Examples of the heterocyclic group include a thiophene ring group and a furan ring group.

n is an integer that is 2 or more and allows the polymer including a recurring unit represented by the General Formula (3) to have a weight average molecular weight of 2,000 or more. p is 0, 1, or 2.

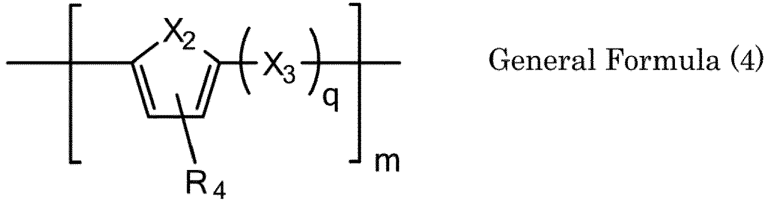

In the General Formula (4), R₄ represents one selected from the group consisting of a hydrogen atom, an alkyl group, an aralkyl group, an alkoxy group, and an aryl group.

Examples of the alkyl group include a methyl group, an ethyl group, and a 2-isobutyl group.

Examples of the aralkyl group include a benzil group and a 2-naphthylmethyl group.

Examples of the alkoxy group include a methoxy group and an ethoxy group.

Examples of the alkenyl group include a vinyl group.

Examples of the aryl group include a phenyl group and a 1-naphthyl group.

X₂ represents one selected from the group consisting of an oxygen atom, a sulfur atom, and a selenium atom.

X₃ represents one selected from the group consisting of an alkenyl group, an alkynyl group, aryl group, and a heterocyclic group.

Examples of the alkenyl group include a vinyl group.

Examples of the alkynyl group include acetylene.

Examples of the aryl group include a phenyl group and a 1-naphthyl group.

Examples of the heterocyclic group include a thiophene ring group and a furan ring group.

m is an integer that is 2 or more and allows the polymer including a recurring unit represented by the General Formula (4) to have a weight average molecular weight of 2,000 or more. q is 0, 1, or 2.

Examples of the polymer including a recurring unit represented by the General Formula (3) include the following (B-1) to (B-19). Note that, n in the General Formula (3) represents an integer that is 2 or more and allows the polymer including a recurring unit represented by the General Formula (3) to have a weight average molecular weight of 2,000 or more.

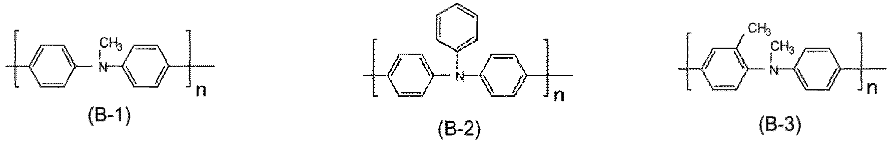

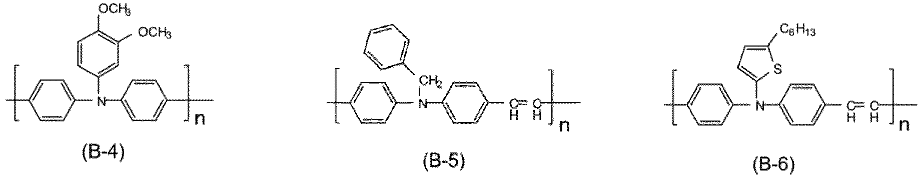

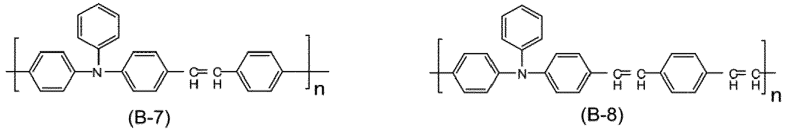

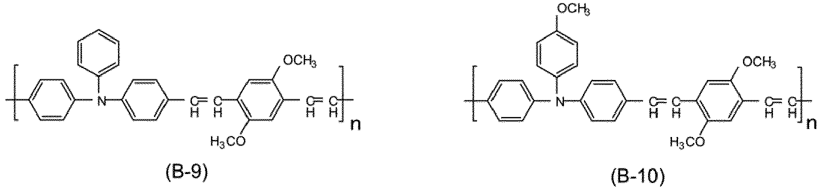

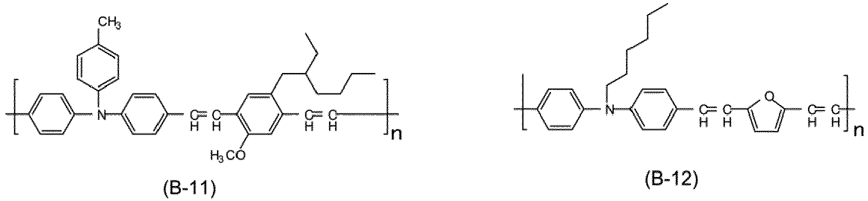

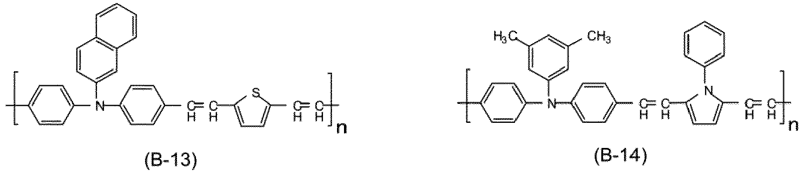

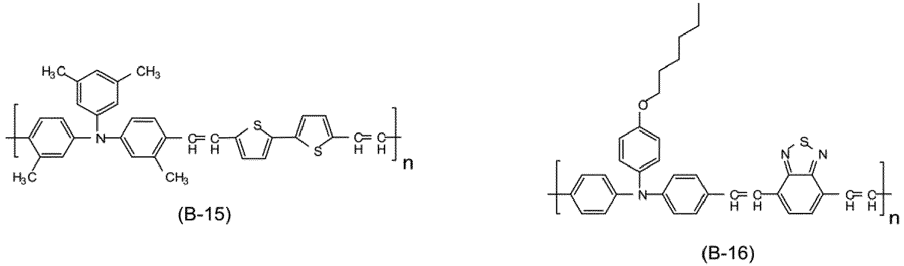

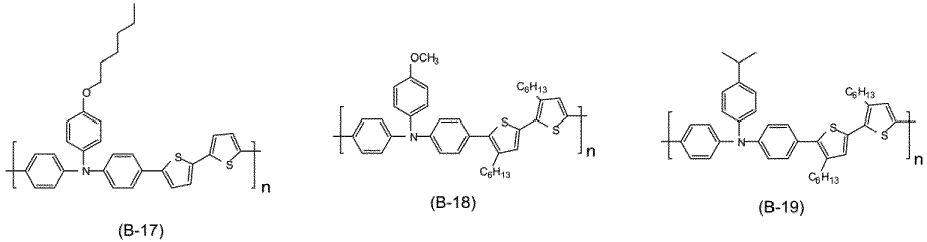

Examples of the polymer having a recurring unit represented by the General Formula (4) include the following (C-1) to (C-21) and (B-22) to (B-32). Note that, m in the General Formula (4) is an integer that is 2 or more and allows the polymer including a recurring unit represented by the General Formula (4) to have a weight average molecular weight of 2,000 or more.

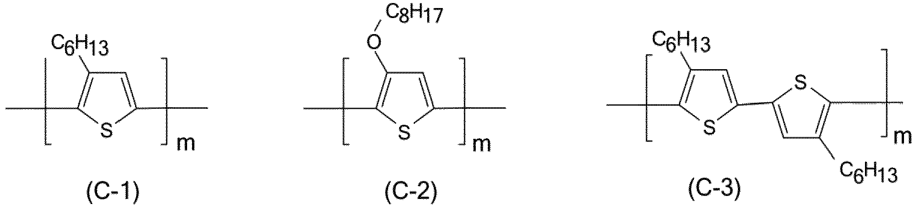

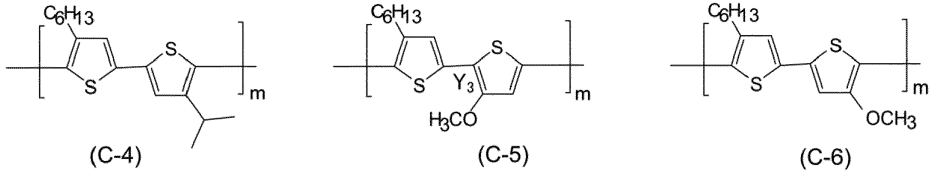

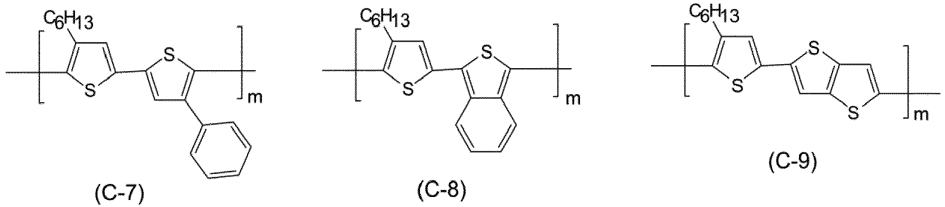

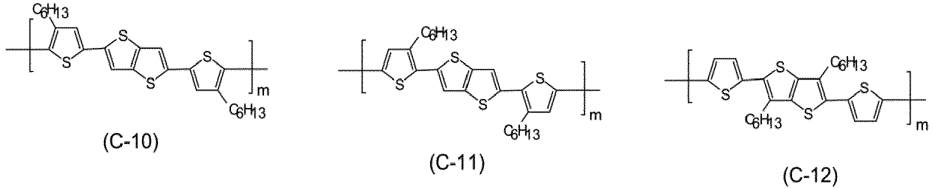

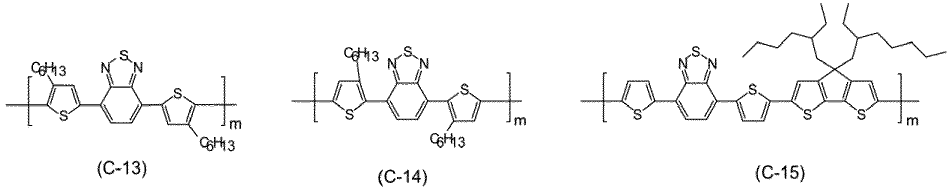

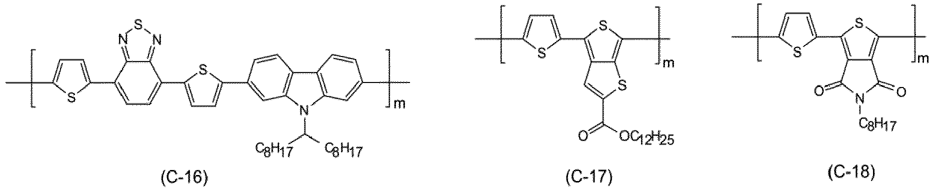

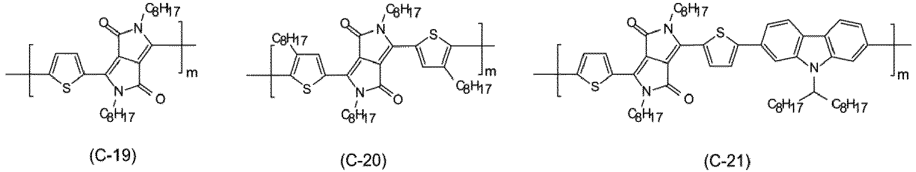

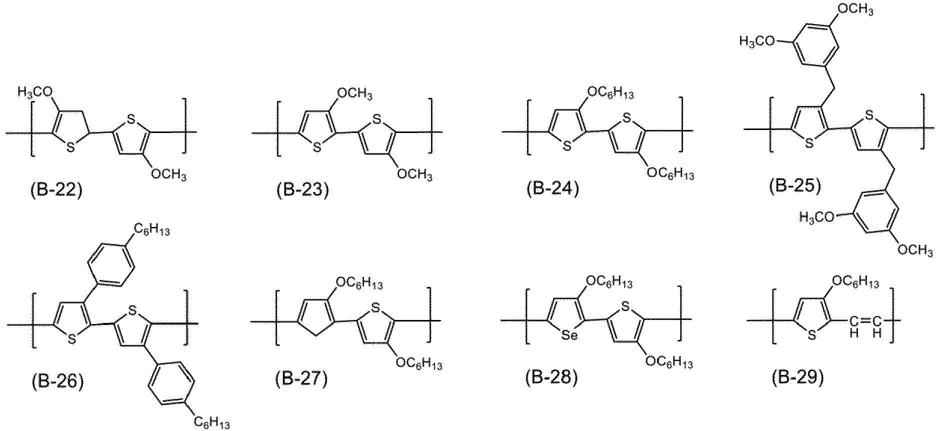

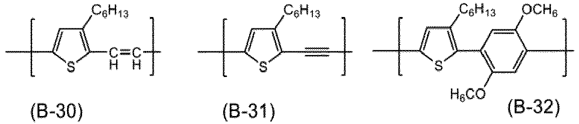

In addition to the aforementioned compounds, a compound included in the hole-transporting layer is not particularly limited and may be appropriately selected depending on the intended purpose. Examples thereof include polythiophene compounds, polyphenylene vinylene compounds, polyfluorene compounds, polyphenylene compounds, polyarylamine compounds, and polythiadiazole compounds. Among them, polythiophene compounds and polyarylamine compounds are preferable in terms of the carrier mobility and the ionization potential.

Examples of the polythiophene compound include poly(3-n-hexylthiophene), poly(3-n-octyloxythiophene), poly(9,9'-dioctyl-fluorene-co-bithiophene), poly(3,3‴-didodecyl-quarter thiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthieno[3,2-b]thiophene-co-thiophene), and poly(3,6-dioctylthieno[3,2-b]thiophene-co-bithiophene).

Examples of the polyphenylene vinylene compound include poly[2-methoxy-5-(2-ethylhexyloxy)-1,4-phenylenevinylenel, poly[2-methoxy-5-(3,7-dimethyloctyloxy)-1,4-phenylenevinylene], and poly[(2-methoxy-5-(2-ethylhexyloxy)-1,4-phenylenevinylene)-co-(4,4'-biphenylene-vinylene)] .

Examples of the polyfluorene compound include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly[(9,9-dioctyl-2,7-diyl)-co-(1,4-(2,5-dihexyloxy)benzene)].

Examples of the polyphenylene compound include poly[2,5-dioctyloxy-1,4-phenylene] and poly[2,5-di(2-ethylhexyloxy-1,4-phenylene].

Examples of the polyarylamine compound include poly[(9,9-dioctylfluorenyl-2,7-diyl)-alt-co-(N,N'-diphenyl)-N,N'-di(p-hexylphenyl)-1,4-diaminobenzenel, poly[(9,9-dioctylfluorenyl-2, 7-diyl)-alt-co-(N,N'-bis(4-octyloxyphenyl)benzidine-N,N'-(1,4-diphenylene)], poly[(N,N'-bis(4-octyloxyphenyl)benzidine-N,N'-(1,4-diphenylene)], poly[(N,N'-bis(4-(2-ethylhexyloxy)phenyl)benzidine-N,N'-(1,4-diphenylene)], poly[phenylimino-1,4-phenylenevinylene-2,5-dioctyloxy-1,4-phenylenevinylene-1,4-phenylene], poly[p-tolylimino-1,4-phenylenevinylene-2,5-di(2-ethylhexyloxy)-1,4-phenylenevinylene-1,4-phenylenel, and poly[4-(2-ethylhexyloxy)phenylimino-1,4-biphenylene].

Examples of the polythiadiazole compound include poly[(9,9-dioctylfluorenyl-2,7-diyl)-alt-co-(1,4-benzo(2,1',3)thiadiazolel and poly(3,4-didecylthiophene-co-(1,4-benzo(2,1',3)thiadiazole).

The hole-transporting layer may include a low-molecular compound alone or may include a mixture of a low-molecular compound and a high-molecular compound, in addition to the aforementioned high-molecular compounds. A chemical structure of the low-molecular hole-transporting material is not particularly limited. Specific examples of the chemical structure of the low-molecular hole-transporting material include oxadiazole compounds described in, for example, Japanese Examined Patent Publication No. 34-5466, triphenylmethane compounds described in, for example, Japanese Examined Patent Publication No. 45-555, pyrazoline compounds described in, for example, Japanese Examined Patent Publication No. 52-4188, hydrazone compounds described in, for example, Japanese Examined Patent Publication No. 55-42380, oxadiazole compounds described in, for example, Japanese Unexamined Patent Application Publication No. 56-123544, tetraarylbenzidine compounds described in Japanese Unexamined Patent Application Publication No. 54-58445 or stilbene compounds described in Japanese Unexamined Patent Application Publication No. 58-65440 or Japanese Unexamined Patent Application Publication No. 60-98437, spirobifluorene compounds described in Japanese Unexamined Patent Application Publication No. 2007-115665, Japanese Unexamined Patent Application Publication No. 2014-72327, Japanese Patent Application No. 2000-067544, JP, WO2004/063283, WO2011/030450, WO2011/45321, WO2013/042699, and WO2013/121835, and thiophene oligomers described in Japanese Unexamined Patent Application Publication No. 2-250881 and Japanese Unexamined Patent Application Publication No. 2013-033868.

In the present disclosure, when a high-molecular compound and a low-molecular compound are mixed, a difference between an ionization potential of the high-molecular compound and an ionization potential of the low-molecular compound is preferably 0.2 eV or less. The ionization potential is energy necessary for taking one electron out from a molecule, and is represented by a unit of an electron volt (eV). A method for measuring the ionization potential is not particularly limited, but is preferably photoelectron spectroscopy.

It is preferable to satisfy the following: IPa - IPb = ±0.2 eV or less, where the IPa is an ionization potential of a high-molecular compound having a molecular weight of 2,000 or more and the IPb is an ionization potential of a compound having a molecular weight of less than 2,000. When the difference is 0.2 eV or more, holes remain trapped in one side to be hardly moved. As a result, holes cannot be smoothly transported.

Other materials included in the hole-transporting layer are not particularly limited and may be appropriately selected depending on the intended purpose. Examples of the other materials include additives and oxidizing agents.

The additive is not particularly limited and may be appropriately selected depending on the intended purpose. Examples of the additive include: iodine; metal iodides such as lithium iodide, sodium iodide, potassium iodide, cesium iodide, calcium iodide, copper iodide, iron iodide, and silver iodide; quaternary ammonium salts such as tetraalkylammonium iodide and pyridinium iodide; metal bromides such as lithium bromide, sodium bromide, potassium bromide, cesium bromide, and calcium bromide; bromine salts of quaternary ammonium compounds such as tetraalkylammonium bromide and pyridinium bromide; metal chlorides such as copper chloride and silver chloride; metal acetates such as copper acetate, silver acetate, and palladium acetate; metal sulfates such as copper sulfate and zinc sulfate; metal complexes such as ferrocyanate-ferricyanate and ferrocene-ferricinium ion; sulfur compounds such as sodium polysulfide and alkylthiol-alkyl disulfide; viologen dyes; hydroquinones; and basic compounds such as pyridine, 4-t-butylpyridine, and benzimidazole.

An oxidizing agent can further be added. A kind of oxidizing agent is not particularly limited and may be appropriately selected depending on the intended purpose. Examples of the oxidizing agent include tris(4-bromophenyl) aminium hexachloroantimonate, silver hexafluoroantimonate, nitrosonium tetrafluoroborate, silver nitrate, and cobalt complex. Note that, it is not necessary to oxidize the entire hole-transporting material with the oxidizing agent, and it is effective so long as the hole-transporting material is partially oxidized. After the reaction, the oxidizing agent may be removed or may not be removed outside the system.

Inclusion of the oxidizing agent in the hole-transporting layer can partially or entirely form the hole-transporting material into radical cations, which makes it possible to improve conductivity and to increase safety and durability of output characteristics.

An average thickness of the hole-transporting layer is not particularly limited and may be appropriately selected depending on the intended purpose. On the perovskite layer, the average thickness of the hole-transporting layer is preferably 0.01 µm or more but 20 µm or less, more preferably 0.1 µm or more but 10 µm or less, and even more preferably 0.2 µm or morebut 2 µm or less.

The perovskite layer can be directly formed on the electron-transporting layer. A method for producing the hole-transporting layer is not particularly limited and may be appropriately selected depending on the intended purpose. Examples of the method include a method where a thin film is formed in vacuum through vacuum deposition and a wet film forming method. In particular, among them, a wet film forming method is preferable, a method where the hole-transporting layer is coated on the perovskite layer is more preferable, in terms of production cost.

The wet film forming method is not particularly limited and may be appropriately selected depending on the intended purpose. Examples thereof include a dip method, a spraying method, a wire bar method, a spin coating method, a roller coating method, a blade coating method, and a gravure coating method. As the wet printing method, methods such as relief printing, offset printing, gravure printing, intaglio printing, rubber plate printing, and screen printing may be used.

Moreover, the hole-transporting layer may be produced, for example, by forming a film in a supercritical fluid or subcritical fluid having a lower temperature and pressure than a critical point.

The supercritical fluid means a fluid, which exists as a non-condensable high-density fluid in a temperature and pressure region exceeding the limit (critical point) at which a gas and a liquid can coexist and does not condense even when being compressed, and is a fluid in a state of being equal to or higher than the critical temperature and is equal to or higher than the critical pressure. The supercritical fluid is not particularly limited and may be appropriately selected depending on the intended purpose. The supercritical fluid is preferably a supercritical fluid having a low critical temperature.

The subcritical fluid is not particularly limited and may be appropriately selected depending on the intended purpose, so long as it is a fluid that exists as a high-pressure liquid in a temperature and pressure region near the critical point. The fluids as exemplified as the supercritical fluid can be suitably used as the subcritical fluid.

Examples of the supercritical fluid include carbon monoxide, carbon dioxide, ammonia, nitrogen, water, alcohol solvents, hydrocarbon solvents, halogen solvents, and ether solvents.

Examples of the alcohol solvent include methanol, ethanol, and n-butanol.

Examples of the hydrocarbon solvent include ethane, propane, 2,3-dimethylbutane, benzene, and toluene. Examples of the halogen solvent include methylene chloride and chlorotrifluoromethane.

Examples of the ether solvent include dimethyl ether.

These may be used alone or in combination.

Among them, since carbon dioxide has a critical pressure of 7.3 MPa and a critical temperature of 31°C, it can easily generate a supercritical state, has incombustibility, and is easily handled, which is preferable.

A critical temperature and a critical pressure of the supercritical fluid are not particularly limited and may be appropriately selected depending on the intended purpose. The critical temperature of the supercritical fluid is preferably -273°C or higher but 300°C or lower, more preferably 0°C or higher but 200°C or lower.

In addition to the supercritical fluid and the subcritical fluid, an organic solvent or an entrainer may be used in combination. The solubility in the supercritical fluid can be more easily adjusted by addition of the organic solvent or the entrainer.

The organic solvent is not particularly limited and may be appropriately selected depending on the intended purpose. Examples thereof include ketone solvents, ester solvents, ether solvents, amide solvents, halogenated hydrocarbon solvents, and hydrocarbon solvents.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diisopropyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

These may be used alone or in combination.

After the hole-transporting material is laminated on the perovskite layer, a press processing step may be performed. By performing the press processing, the hole-transporting material closely adheres to the perovskite layer, which may improve the photoelectric conversion efficiency in some cases.

A method of the press processing is not particularly limited and may be appropriately selected depending on the intended purpose. Examples thereof include the press molding method using a plate, which is represented by the infrared spectroscopy (IR) tableting machine and the roll press method using a roller.

A pressure at which the press processing is performed is preferably 10 kgf/cm² or more, more preferably 30 kgf/cm² or more.

The pressing time is not particularly limited and may be appropriately selected depending on the intended purpose. The pressing time is preferably 1 hour or shorter. Moreover, heat may be applied at the time of the pressing.

At the time of the pressing, a release agent may be disposed between a pressing machine and an electrode.

The release agent is not particularly limited and may be appropriately selected depending on the intended purpose. Examples thereof include fluoro resins such as polyethylene tetrafluoride, polychloroethylene trifluoride, ethylene tetrafluoride-propylene hexafluoride copolymers, perfluoroalkoxy fluoride resins, polyvinylidene fluoride, ethylene-ethylene tetrafluoride copolymers, ethylene-chloroethylene trifluoride copolymers, and polyvinyl fluoride. These may be used alone or in combination.

After performing the pressing but before disposing a second electrode, a film including the metal oxide may be disposed between the hole-transporting layer and the second electrode.

The metal oxide is not particularly limited and may be appropriately selected depending on the intended purpose. Examples of thereof include molybdenum oxide, tungsten oxide, vanadium oxide, and nickel oxide. These may be used alone or in combination. Among them, molybdenum oxide is preferable.

A method for disposing the film including the metal oxide on the hole-transporting layer is not particularly limited and may be appropriately selected depending on the intended purpose. Examples of the method include a method where a thin film is formed in vacuum such as sputtering and vacuum vapor deposition, and a wet film forming method.

The wet film forming method in the case where the film including the metal oxide is formed is preferably a method where a paste obtained by dispersing powder or sol of the metal oxide is prepared and is coated on the hole-transporting layer.

The wet film forming method is not particularly limited and may be appropriately selected depending on the intended purpose. Examples of the wet film forming method include a dip method, a spraying method, a wire bar method, a spin coating method, a roller coating method, a blade coating method, and a gravure coating method. As the wet printing method, methods such as relief printing, offset printing, gravure printing, intaglio printing, rubber plate printing, and screen printing may be used.

An average thickness of the film including the metal oxide is not particularly limited and may be appropriately selected depending on the intended purpose. However, the average thickness thereof is preferably 0.1 nm or more but 50 nm or less, more preferably 1 nm or more but 10 nm or less.

### <First electrode>

A shape and a size of the first electrode is not particularly limited and may be appropriately selected depending on the intended purpose, so long as the first electrodes in at least two photoelectric conversion elements adjacent to each other are separated by the hole-transporting layer.

A structure of the first electrode is not particularly limited and may be appropriately selected depending on the intended purpose. The structure of the first electrode may be a single layer structure or a structure where a plurality of materials are laminated.

A material of the first electrode is not particularly limited and may be appropriately selected depending on the intended purpose, so long as it has electric conductivity. Examples of the material include transparent conductive metal oxides, carbon, and metals.

Examples of the transparent conductive metal oxide include indium-tin oxide (referred to as "ITO" hereinafter), fluorine-doped tin oxide (referred to as "FTO" hereinafter), antimony-doped tin oxide (referred to as "ATO" hereinafter), niobium-doped tin oxide (referred to as "NTO" hereinafter), aluminum-doped zinc oxide, indium-zinc oxide, and niobium-titanium oxide.

Examples of the carbon include carbon black, carbon nanotube, graphene, and fullerene.

Examples of the metal include gold, silver, aluminum, nickel, indium, tantalum, and titanium.

These may be used alone or in combination. Among them, a transparent conductive metal oxide having high transparency is preferable, ITO, FTO, ATO, and NTO are more preferable.

An average thickness of the first electrode is not particularly limited and may be appropriately selected depending on the intended purpose. The average thickness of the first electrode is preferably 5 nm or more but 100 µm or less, more preferably 50 nm or more but 10 µm or less. When a material of the first electrode is carbon or metal, the average thickness of the first electrode is preferably an average thickness enough for obtaining translucency.

The first electrode can be formed by known methods such as a sputtering method, a vapor deposition method, and a spraying method.

Moreover, the first electrode is preferably formed on the first substrate. It is possible to use an integrated commercially available product where the first electrode has been formed on the first substrate in advance.

Examples of the integrated commercially available product include FTO coated glass, ITO coated glass, zinc oxide/aluminum coated glass, an FTO coated transparent plastic film, and an ITO coated transparent plastic film. Other examples of the integrated commercially available product include glass substrates provided with a transparent electrode where tin oxide or indium oxide is doped with a cation or an anion having a different atomic value and glass substrates provided with a metal electrode having such a structure that allows light in the form of a mesh or stripes to pass.

These may be used alone, or two or more products may be used in combination as a combined product or a laminate. Moreover, a metal lead wire may be used in combination in order to decrease an electric resistance value.

A material of the metal lead wire is, for example, aluminum, copper, silver, gold, platinum, and nickel.

The metal lead wire can be used in combination by forming it on the first substrate through, for example, vapor deposition, sputtering, or pressure bonding, and disposing a layer of ITO or FTO thereon, or by forming it on ITO or FTO.

### <Electron-transporting layer>

The electron-transporting layer means a layer that transports, to the first electrode, electrons generated in a perovskite layer that will be described hereinafter. Therefore, the electron-transporting layer is preferably disposed adjacent to the first electrode.

A shape and a size of the electron-transporting layer are not particularly limited and may be appropriately selected depending on the intended purpose, so long as the electron-transporting layers in at least two photoelectric conversion elements adjacent to each other are separated by the hole-transporting layer.

When the electron-transporting layers in at least two photoelectric conversion elements adjacent to each other are separated by the hole-transporting layer, diffusion of electrons is prevented to decrease leakage of electric current. As a result, light durability can be improved.

A structure of the electron-transporting layer may be a single layer or a multilayer formed by laminating a plurality of layers. However, the structure thereof is preferably a multilayer. The structure thereof is more preferably formed of a layer having a compact structure (compact layer) and a layer having a porous structure (porous layer). In addition, the compact layer is preferably disposed closer to the first electrode than the porous layer.

### <<Compact layer>>

The compact layer is not particularly limited and may be appropriately selected depending on the intended purpose, so long as it includes an electron-transporting material and is more compact than a porous layer that will be described hereinafter. Here, being more compact than the porous layer means that a packing density of the compact layer is higher than a packing density of particles of which the porous layer is formed.

The electron-transporting material is not particularly limited and may be appropriately selected depending on the intended purpose, but is preferably a semiconductor material.

The semiconductor material is not particularly limited and known materials can be used. Examples thereof include simple substance semiconductors and compound semiconductors.

Examples of the simple substance semiconductor include silicon and germanium.

Examples of the compound semiconductor include chalcogenides of metal. Specific examples thereof include: oxides of titanium, tin, zinc, iron, tungsten, zirconium, hafnium, strontium, indium, cerium, yttrium, lanthanum, vanadium, niobium, and tantalum; sulfides of cadmium, zinc, lead, silver, antimony, and bismuth; selenides of cadmium and lead; and tellurium compounds of cadmium. Examples of the other compound semiconductor include: phosphides of zinc, gallium, indium, and cadmium; gallium arsenide; copper-indium-selenide, and copper-indium-sulfide.

Among them, oxide semiconductors are preferable. Particularly, titanium oxide, zinc oxide, tin oxide, and niobium oxide are preferably included.

These may be used alone or in combination. A crystal type of the semiconductor material is not particularly limited and may be appropriately selected depending on the intended purpose. The crystal type thereof may be a single crystal, polycrystalline, or amorphous.

A film thickness of the compact layer is not particularly limited and may be appropriately selected depending on the intended purpose. The film thickness of the compact layer is preferably 5 nm or more but 1 µm or less, more preferably 10 nm or more but 700 nm or less.

A method for producing the compact layer is not particularly limited and may be appropriately selected depending on the intended purpose. Examples of the method include a method for forming a thin film under vacuum (vacuum film formation method) and a wet film formation method.

Examples of the vacuum film formation method include a sputtering method, a pulse laser deposition method (PLD method), an ion beam sputtering method, an ion assisted deposition method, an ion plating method, a vacuum deposition method, an atomic layer deposition method (ALD method), and a chemical vapor deposition method (CVD method).

Examples of the wet film formation method include a sol-gel method. The sol-gel method is the following method. Specifically, a solution is allowed to undergo a chemical reaction such as hydrolysis or polymerization·condensation to prepare gel. Then, it is subjected to a heat treatment to facilitate compactness. When the sol-gel method is used, a method for coating the sol solution is not particularly limited and may be appropriately selected depending on the intended purpose. Examples thereof include a dip method, a spraying method, a wire bar method, a spin coating method, a roller coating method, a blade coating method, a gravure coating method, and wet printing methods such as relief printing, offset printing, gravure printing, intaglio printing, rubber plate printing, and screen printing. A temperature at which the heat treatment is performed after the sol solution is coated is preferably 80°C or more, more preferably 100°C or more.

### <<Porous layer>>

The porous layer is not particularly limited and may be appropriately selected depending on the intended purpose, so long as it is a layer that includes an electron-transporting material and is less compact (i.e., porous) than the compact layer. Note that, being less compact than the compact layer means that a packing density of the porous layer is lower than a packing density of the compact layer.

The electron-transporting material is not particularly limited and may be appropriately selected depending on the intended purpose, but is preferably a semiconductor material similarly to the case of the compact layer. As the semiconductor material, the same materials as the materials used in the compact layer can be used.

In addition, the electron-transporting material constituting the porous layer has a particulate shape, and these particles are preferably joined to form a porous film.

A number average particle diameter of primary particles of the electron-transporting material is not particularly limited and may be appropriately selected depending on the intended purpose. The number average particle diameter thereof is preferably 1 nm or more but 100 nm or less, more preferably 10 nm or more but 50 nm or less. Moreover, a semiconductor material having a lager particle size than the number average particle diameter may be mixed or laminated. Use of such a semiconductor material may improve a conversion efficiency because of an effect of scattering incident light. In this case, the number average particle diameter thereof is preferably 50 nm or more but 500 nm or less.

As the electron-transporting material in the porous layer, titanium oxide particles can be suitably used. When the electron-transporting material in the porous layer is titanium oxide particles, the conduction band is high, which makes it possible to obtain a high open-circuit voltage. When the electron-transporting material in the porous layer is the titanium oxide particles, the refractive index is high, and a high short circuit current can be obtained because of an effect of confining light. Moreover, when the electron-transporting material in the porous layer is the titanium oxide particles, it is advantageous because the permittivity of the porous layer becomes high and the mobility of the electrons becomes high to obtain a high fill factor (shape factor). That is, the electron-transporting layer preferably includes the porous layer including titanium oxide particles because the open-circuit voltage and the fill factor can be improved.

An average thickness of the porous layer is not particularly limited and may be appropriately selected depending on the intended purpose. The average thickness thereof is preferably 30 nm or more but 1 µm or less, more preferably 100 nm or more but 600 nm or less.

Moreover, the porous layer may include a multilayer structure. The porous layer having a multilayer structure can be produced by coating a dispersion liquid of particles of the electron-transporting material different in a particle diameter several times, or by coating a dispersion liquid of the electron-transporting material, a resin, and an additive different in formulation several times. It is effective to coat the dispersion liquid of particles of the electron-transporting material several times when an average thickness (film thickness) of the porous layer is adjusted.

A method for producing the porous layer is not particularly limited and may be appropriately selected depending on the intended purpose. Examples of the method include an immersion method, a spin coating method, a spraying method, a dip method, a roller method, and an air knife method. As the method for producing the porous layer, a precipitation method using a supercritical fluid such as carbon dioxide can be used.

A method for preparing particles of the electron-transporting material is, for example, a method where the material is mechanically pulverized using a milling device known in the art. According to the method, a dispersion liquid of the semiconductor material can be prepared by dispersing a particulate electron-transporting material alone or a mixture of the semiconductor material and a resin in water or a solvent.

Examples of the resin include polymers or copolymers of vinyl compounds (e.g., styrene, vinyl acetate, acrylic acid ester, and methacrylic acid ester), silicone resins, phenoxy resins, polysulfone resins, polyvinyl butyral resins, polyvinyl formal resins, polyester resins, cellulose ester resins, cellulose ether resins, urethane resins, phenol resins, epoxy resins, polycarbonate resins, polyarylate resins, polyamide resins, and polyimide resins. These may be used alone or in combination.

Examples of the solvent include water, alcohol solvents, ketone solvents, ester solvents, ether solvents, amide solvents, halogenated hydrocarbon solvents, and hydrocarbon solvents.

Examples of the alcohol solvent include methanol, ethanol, isopropyl alcohol, and α-terpineol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

These may be used alone or in combination.

To the dispersion liquid including the electron-transporting material or the paste including the electron-transporting material obtained by, for example, the sol-gel method, acid, a surfactant, or a chelating agent may be added in order to prevent reaggregation of the particles.

Examples of the acid include hydrochloric acid, nitric acid, and acetic acid.

Examples of the surfactant include polyoxyethylene octylphenyl ether.

Examples of the chelating agent include acetyl acetone, 2-aminoethanol, and ethylene diamine.

Moreover, addition of a thickener is also an effective means for the purpose of improving film forming ability.

Examples of the thickener include polyethylene glycol, polyvinyl alcohol, and ethyl cellulose.

After the electron-transporting material is coated, it is possible to electronically contact particles of the electron-transporting material with each other, followed by baking, irradiation of microwave or electron beams, or irradiation of laser light in order to improve strength of the film and adhesiveness to the first substrate. These treatments may be performed alone or in combination.

When the porous layer formed of the electron-transporting material is baked, a baking temperature is not particularly limited and may be appropriately selected depending on the intended purpose. However, the baking temperature thereof is preferably 30°C or more but 700°C or less, more preferably 100°C or more but 600°C or less. When the baking temperature thereof is 30°C or more but 700°C or less, the porous layer can be baked while the first substrate is prevented from being increased in a resistance value and being melted. The baking time is not particularly limited and may be appropriately selected depending on the intended purpose, but is preferably 10 minutes or more but 10 hours or less.

When the porous layer formed of the electron-transporting material is irradiated with microwave, the irradiation time is not particularly limited and may be appropriately selected depending on the intended purpose, but is preferably 1 hour or less. In this case, light may be emitted from a surface side on which the porous layer is formed, and light may be emitted from a surface side on which the porous layer is not formed.

After the porous layer formed of the electron-transporting material is baked, a chemical plating treatment using a mixed solution of an aqueous titanium tetrachloride solution or an organic solvent or an electrochemical plating treatment using an aqueous titanium trichloride solution may be performed for the purpose of increasing a surface area of the porous layer.

In this way, the film obtained by, for example, baking the electron-transporting material having a diameter of several tens of nanometers has a porous structure having many voids. The porous structure has a considerably high surface area and the surface area can be represented by a roughness factor. The roughness factor is a numerical value presenting an actual area of the inside of the porous bodies relative to an area of particles of the electron-transporting material coated on the first substrate or the compact layer. Therefore, a larger roughness factor is preferable, but the roughness factor is preferably 20 or more in terms of relationship between the roughness factor and an average thickness of the electron-transporting layer.

The particles of the electron-transporting material may be doped with a lithium compound. A specific method thereof is a method where a solution of a lithium bis(trifluoromethanesulfonimide) compound is deposited on the particles of the electron-transporting material through, for example, spin coating, followed by a baking treatment.

The lithium compound is not particularly limited and may be appropriately selected depending on the intended purpose. Examples of the lithium compound include lithium bis(trifluoromethanesulfonimide), lithium perchlorate, and lithium iodide.

### <Perovskite layer>

The perovskite layer means a layer containing a perovskite compound.

A shape and a size of the perovskite layer are not particularly limited and may be appropriately selected depending on the intended purpose, so long as the perovskite layers in at least two photoelectric conversion elements adjacent to each other are separated by the hole-transporting layer.

The perovskite compound is a compound represented by the following General Formula (5).

X *α* Y *β* Z *γ* General Formula (5)

In the General Formula (5), a ratio of α: β: γ is 3: 1: 1, and β and γ are an integer of more than 1. X represents a halogen ion, Y represents an organic compound including an amino group, and Z represents a metal ion. The perovskite layer is preferably disposed adjacent to the electron-transporting layer.

The ratio of α: β: γ is not necessarily 3: 1: 1, and may be, for example, 3: 1.05: 0.95.

X in the General Formula (5) is not particularly limited and may be appropriately selected depending on the intended purpose. Examples thereof include halogen ions such as chlorine, bromine, and iodine. These may be used alone or in combination.

Examples of Y in the General Formula (5) include alkylamine compound ions (organic compounds containing an amino group) (e.g., methylamine, ethylamine, n-butylamine, and formamidine). However, the examples of Y in the General Formula (5) are not limited to organic matters, and may be, for example, alkali metal ions of, for example, cesium, potassium, and rubidium. The alkylamine compound ion and the alkali metal ion may be used alone or in combination. The organic matter (alkylamine compound ion) and the inorganic matter (alkali metal ion) may be used in combination (e.g., combination of a cesium ion and formamidine). Alternatively, in the case of the perovskite compound of lead halide-methylammonium, the peak λmax of light-absorbing spectrum is about 350 nm when the halogen ion is Cl, the peak λmax thereof is about 410 nm when the halogen ion is Br, and the peak λmax thereof is about 540 nm when the halogen ion is I. That is, the peaks Xmax are shifted to a side of a long-wavelength side in this order, and a usable spectrum width (band width) is different.

Z in the General Formula (5) is not particularly limited and may be appropriately selected depending on the intended purpose. Examples thereof include metals such as lead, indium, antimony, tin, copper, and bismuth. These may be used alone or in combination. Particularly, lead and antimony are preferably used in combination.

The perovskite layer preferably has a laminated perovskite structure where a layer formed of metal halide and a layer of arranged organic cation molecules are alternatively laminated.

The perovskite layer preferably includes at least one selected from the group consisting of an alkali metal and an antimony atom. Inclusion of at least one selected from the group consisting of an alkali metal and an antimony atom in the perovskite layer is advantageous because the output becomes high. Examples of the alkali metal include cesium, rubidium, and potassium. Among them, cesium is preferable. Moreover, inclusion of an antimony atom is particularly preferable in place of a part of lead, as described above.

A method for forming the perovskite layer is not particularly limited and may be appropriately selected depending on the intended purpose. Examples of the method include a method where a solution obtained by dissolving or dispersing metal halide and halogenated alkylamine is coated, followed by drying.

Examples of the method for forming the perovskite layer include a two-step precipitation method where a solution obtained by dissolving or dispersing metal halide is coated and dried, and the resultant is immersed in a solution obtained by dissolving halogenated alkylamine to thereby form a perovskite compound.

Moreover, one example of the method for forming the perovskite layer is, for example, a method where a solution obtained by dissolving or dispersing metal halide and halogenated alkylamine is coated while a poor solvent (a solvent having a small solubility) for the perovskite compound is added thereto, to thereby precipitate crystals. In addition, examples of the method for forming the perovskite layer include a method where metal halide is deposited in a gas filled with, for example, methylamine.

Among them, preferable is a method where a solution obtained by dissolving or dispersing metal halide and halogenated alkylamine is coated while a poor solvent for the perovskite compound is added thereto, to thereby precipitate crystals.

A method for coating a solution is not particularly limited and may be appropriately selected depending on the intended purpose. Examples of the method include an immersion method, a spin-coating method, a spray method, a dip method, a roller method, and an air knife method. The method for coating a solution may be, for example, a method where precipitation is performed in a supercritical fluid using, for example, carbon dioxide.

The perovskite layer may include a sensitizing dye.

A method for forming the perovskite layer including a sensitizing dye is not particularly limited and may be appropriately selected depending on the intended purpose. Examples of the method include: a method where a perovskite compound and a sensitizing dye are mixed; and a method where a perovskite layer is formed and then a sensitizing dye is adsorbed thereon.

The sensitizing dye is not particularly limited and may be appropriately selected depending on the intended purpose, so long as it is a compound photoexcited by excitation light to be used.

Examples of the sensitizing dye include: metal-complex compounds described in, for example, Japanese Translation of PCT International Application Publication No. JP-T-07-500630, Japanese Unexamined Patent Application Publication No. 10-233238, Japanese Unexamined Patent Application Publication No. 2000-26487, Japanese Unexamined Patent Application Publication No. 2000-323191, and Japanese Unexamined Patent Application Publication No. 2001-59062; coumarin compounds described in, for example, Japanese Unexamined Patent Application Publication No. 10-93118, Japanese Unexamined Patent Application Publication No. 2002-164089, Japanese Unexamined Patent Application Publication No. 2004-95450, and J. Phys. Chem. C, 7224, Vol. 111 (2007); polyene compounds described in, for example, Japanese Unexamined Patent Application Publication No. 2004-95450 and Chem. Commun., 4887 (2007); indoline compounds described in, for example, Japanese Unexamined Patent Application Publication No. 2003-264010, Japanese Unexamined Patent Application Publication No. 2004-63274, Japanese Unexamined Patent Application Publication No. 2004-115636, Japanese Unexamined Patent Application Publication No. 2004-200068, Japanese Unexamined Patent Application Publication No. 2004-235052, J. Am. Chem. Soc., 12218, Vol. 126 (2004), Chem. Commun., 3036 (2003), and Angew. Chem. Int. Ed., 1923, Vol. 47 (2008); thiophene compounds described in, for example, J. Am. Chem. Soc., 16701, Vol. 128 (2006), and J. Am. Chem. Soc., 14256, Vol. 128 (2006); cyanine dyes described in, for example, Japanese Unexamined Patent Application Publication No. 11-86916, Japanese Unexamined Patent Application Publication No. 11-214730, Japanese Unexamined Patent Application Publication No. 2000-106224, Japanese Unexamined Patent Application Publication No. 2001-76773, and Japanese Unexamined Patent Application Publication No. 2003-7359; merocyanine dyes described in, for example, Japanese Unexamined Patent Application Publication No. 11-214731, Japanese Unexamined Patent Application Publication No. 11-238905, Japanese Unexamined Patent Application Publication No. 2001-52766, Japanese Unexamined Patent Application Publication No. 2001-76775, and Japanese Unexamined Patent Application Publication No. 2003-7360; 9-aryl xanthene compounds described in, for example, Japanese Unexamined Patent Application Publication No. 10-92477, Japanese Unexamined Patent Application Publication No. 11-273754, Japanese Unexamined Patent Application Publication No. 11-273755, and Japanese Unexamined Patent Application Publication No. 2003-31273; triarylmethane compounds described in, for example, Japanese Unexamined Patent Application Publication No. 10-93118 and Japanese Unexamined Patent Application Publication No. 2003-31273; and phthalocyanine compounds and porphyrin compounds described in, for example, Japanese Unexamined Patent Application Publication No. 09-199744, Japanese Unexamined Patent Application Publication No. 10-233238, Japanese Unexamined Patent Application Publication No. 11-204821, Japanese Unexamined Patent Application Publication No. 11-265738, J. Phys. Chem., 2342, Vol. 91 (1987), J. Phys. Chem. B, 6272, Vol. 97 (1993), Electroanal. Chem., 31, Vol. 537 (2002), Japanese Unexamined Patent Application Publication No. 2006-032260, J. Porphyrins Phthalocyanines, 230, Vol. 3 (1999), Angew. Chem. Int. Ed., 373, Vol. 46 (2007), and Langmuir, 5436, Vol. 24 (2008). Among them, metal-complex compounds, indoline compounds, thiophene compounds, and porphyrin compounds are preferable.

### <Second electrode>

The second electrode is preferably formed on the hole-transporting layer or a film of the metal oxide in the hole-transporting layer. The second electrode can include the same as the first electrode.

A shape, a structure, and a size of the second electrode are not particularly limited and may be appropriately selected depending on the intended purpose.

Examples of a material of the second electrode include metals, carbon compounds, conductive metal oxides, and conductive polymers.

Examples of the metal include platinum, gold, silver, copper, and aluminum.

Examples of the carbon compound include graphite, fullerene, carbon nanotube, and graphene.

Examples of the conductive metal oxide include ITO, FTO, and ATO.

Examples of the conductive polymer include polythiophene and polyaniline.

These may be used alone or in combination.

The second electrode can be appropriately formed on the hole-transporting layer by a method such as coating, laminating, vacuum deposition, CVD, or bonding, depending on a kind of material to be used or a kind of hole-transporting layer.

In the photoelectric conversion element, at least one of the first electrode and the second electrode is preferably substantially transparent. When the photoelectric conversion module of the present disclosure is used, the first electrode is preferably transparent to allow entrance of incident light from a side of the first electrode. In this case, a material that reflects light is preferably used for the second electrode, and glass, plastic, and a metal thin film on which a metal or conductive oxide is deposited are preferably used. In addition, provision of an anti-reflection layer at a side of the electrode into which the incident light enters is an effective means.

### <Other members>

The other members are not particularly limited and may be appropriately selected depending on the intended purpose. Preferable examples of the other members include a first substrate, a second substrate, and a sealing member.

### «First substrate»

A shape, a structure, and a size of the first substrate are not particularly limited and may be appropriately selected depending on the intended purpose.

The material of the first substrate is not particularly limited and may be appropriately selected depending on the intended purpose, so long as it has transparency and an insulation property. Examples of the material include glass, plastic films, and ceramics. Among them, a material having heat resistance against a baking temperature is preferable when the baking step is performed to form the electron-transporting layer. Moreover, the first substrate is preferably a substrate having flexibility.

### <<Second substrate>>

The second substrate is disposed so as to face the first substrate, so that the first substrate and the second substrate sandwich the photoelectric conversion elements.

A shape, a structure, and a size of the second substrate is not particularly limited and may be appropriately selected depending on the intended purpose.

A material of the second substrate is not particularly limited and may be appropriately selected depending on the intended purpose. Examples of the material include glass, plastic films, and ceramics.

A convex-concave part may be formed at a connection part of the second substrate with a sealing member, which will be described hereinafter, in order to increase adhesiveness.

A formation method of the convex-concave part is not particularly limited and may be appropriately selected depending on the intended purpose. Examples of the formation method include a sand blasting method, a water blasting method, a chemical etching method, a laser processing method, and a method using abrasive paper.

A method for increasing adhesiveness between the second substrate and the sealing member may be, for example, a method where an organic matter on the surface of the second substrate is removed, or a method for improving hydrophilicity of the second substrate. The method for removing an organic matter on the surface of the second substrate is not particularly limited and may be appropriately selected depending on the intended purpose. Examples of the method include UV ozone washing and an oxygen plasma treatment.

### «Sealing member»

The sealing member is disposed between the first substrate and the second substrate, and seals the photoelectric conversion elements.

A material of the sealing member is not particularly limited and may be appropriately selected depending on the intended purpose. Examples thereof include cured products of acrylic resins and cured products of epoxy resins.

As the cured product of the acrylic resin, any of materials known in the art can be used, so long as the cured product of the acrylic resin is a product obtained by curing a monomer or oligomer including an acryl group in a molecule thereof.

As the cured product of the epoxy resin, any of materials known in the art can be used, so long as the cured product of the epoxy resin is a product obtained by curing a monomer or oligomer including an epoxy group in a molecule thereof.

Examples of the epoxy resin include water-dispersing epoxy resins, non-solvent epoxy resins, solid epoxy resins, heat-curable epoxy resins, curing agent-mixed epoxy resins, and ultraviolet-ray-curable epoxy resins. Among them, heat-curable epoxy resins and ultraviolet-ray-curable epoxy resins are preferable, ultraviolet-ray-curable epoxy resins are more preferable. Note that, heating may be performed even when an ultraviolet-ray-curable epoxy resin is used, and heating is preferably performed even after curing through ultraviolet ray irradiation.

Examples of the epoxy resin include bisphenol A-based epoxy resins, bisphenol F-based epoxy resins, novolac-based epoxy resins, alicyclic epoxy resins, long-chain aliphatic epoxy resins, glycidyl amine-based epoxy resins, glycidyl ether-based epoxy resins, and glycidyl ester-based epoxy resins. These may be used alone or in combination.

Moreover, a curing agent or various additives are preferably mixed with the epoxy resin if necessary.

The curing agent is not particularly limited and may be appropriately selected depending on the intended purpose. The curing agents are classified into, for example, amine-based curing agents, acid anhydride-based curing agents, polyamide-based curing agents, and other curing agents.

Examples of the amine-based curing agent include: aliphatic polyamine such as diethylenetriamine and triethylenetetramine; and aromatic polyamine such as methphenylenediamine, diaminodiphenylmethane, and diaminodiphenylsulfone.

Examples of the acid anhydride-based curing agent include phthalic anhydride, tetrahydrophthalic anhydride, hexahydrophthalic anhydride, methyltetrahydrophthalic anhydride, methylnadic anhydride, pyromellitic anhydride, HET anhydride, and dodecenylsuccinic anhydride.

Examples of other curing agents include imidazoles and polymercaptan. These may be used alone or in combination.

The additive is not particularly limited and may be appropriately selected depending on the intended purpose. Examples of the additive include fillers, gap agents, polymerization initiators, drying agents (moisture absorbents), curing accelerators, coupling agents, flexibilizers, colorants, flame retardant auxiliaries, antioxidants, and organic solvents. Among them, fillers, gap agents, curing accelerators, polymerization initiators, and drying agents (moisture absorbents) are preferable, and fillers and polymerization initiators are more preferable.

Inclusion of the filler as the additive prevents entry of moisture or oxygen, and further can achieve effects such as reduction in volumetric shrinkage at the time of curing, reduction in an amount of outgas at the time of curing or heating, improvement of mechanical strength, and control of thermal conductivity or fluidity. Therefore, inclusion of the filler as the additive is very effective in maintaining stable output under various environments.

In addition, it is not possible to ignore not only an influence of entry of moisture or oxygen, but also an influence of outgas generated at the time of curing or heating the sealing member, regarding output properties or durability of a photoelectric conversion element. Especially, the influence of outgas generated at the time of heating greatly affects output properties of the photoelectric conversion element stored in a high temperature environment.

When the sealing member includes a filler, a gap agent, or a drying agent, they can prevent entry of moisture or oxygen. In addition, because an amount of the sealing member to be used can be reduced, an effect of reducing outgas can be obtained. Inclusion of the filler, the gap agent, or the drying agent into the sealing member is effective not only at the time of curing but also at the time when the photoelectric conversion element is stored under a high temperature environment.

The filler is not particularly limited and may be appropriately selected depending on the intended purpose. Examples of the filler include inorganic fillers such as crystalline or amorphous silica, talc, alumina, aluminum nitride, silicon nitride, calcium silicate, and calcium carbonate. These may be used alone or in combination.

An average primary particle diameter of the filler is preferably 0.1 µm or more but 10 µm or less, more preferably 1 µm or more but 5 µm or less. When the average primary particle diameter of the filler falls within the above preferable range, an effect of preventing entry of moisture or oxygen can be sufficiently obtained, the viscosity becomes appropriate, and adhesiveness to a substrate or a defoaming property is improved. In addition, it is also effective in terms of control of a width of the sealing part and workability.

An amount of the filler is preferably 10 parts by mass or more but 90 parts by mass or less, more preferably 20 parts by mass or more but 70 parts by mass or less, relative to the entire sealing member (100 parts by mass). When the amount of the filler falls within the above preferable range, an effect of preventing entry of moisture or oxygen can be sufficiently obtained, the viscosity becomes appropriate, and adhesiveness and workability are good.

The gap agent is also called a gap controlling agent or a spacer agent. By including the gap agent as the additive, it is possible to control the gap of the sealing part. For example, when a sealing member is provided on a first substrate or a first electrode and a second substrate is provided thereon for sealing, a gap of the sealing part is matched with a size of the gap agent because the sealing member includes the gap agent. As a result, it is possible to easily control the gap of the sealing part.

The gap agent is not particularly limited and may be appropriately selected depending on the intended purpose, so long as it is particulate, has a uniform particle diameter, and has high solvent resistance and heat resistance. The gap agent is preferably a material which has high affinity to an epoxy resin and is in the form of sphere particles. Specific examples thereof include glass beads, silica fine particles, and organic resin fine particles. These may be used alone or in combination.

A particle diameter of the gap agent can be selected depending on a gap of the sealing part to be set. The particle diameter of the gap agent is preferably 1 µm or more but 100 µm or less, more preferably 5 µm or more but 50 µm or less.

The polymerization initiator is not particularly limited and may be appropriately selected depending on the intended purpose, so long as polymerization is initiated through heat or light. Examples of the polymerization initiator include thermal polymerization initiators and photopolymerization initiators.

The thermal polymerization initiator is a compound that generates active species such as radicals and cations upon heating. Examples of the thermal polymerization initiator include azo compounds such as 2,2'-azobisbutyronitrile (AIBN) and peroxides such as benzoyl peroxide (BPO). Examples of the thermal cationic polymerization initiator include benzenesulfonic acid esters and alkyl sulfonium salts.

Meanwhile, as the photopolymerization initiator, a photocationic polymerization initiator is preferably used in the case of the epoxy resin. When the photocationic polymerization initiator is mixed with the epoxy resin and light is emitted, the photocationic polymerization initiator is decomposed to generate an acid, and the acid induces polymerization of the epoxy resin. Then, curing reaction proceeds. The photocationic polymerization initiator has such effects that less volumetric shrinkage during curing is caused, oxygen inhibition does not occur, and storage stability is high.

Examples of the photocationic polymerization initiator include aromatic diazonium salts, aromatic iodonium salts, aromatic sulfonium salts, metallocene compounds, and silanol-aluminum complexes.

Moreover, a photoacid generator having a function of generating an acid upon irradiation of light can be also used as the polymerization initiator. The photoacid generator functions as an acid for initiating cationic polymerization. Examples of the photoacid generator include onium salts such as ionic sulfonium salt-based onium salts and ionic iodonium salt-based onium salts including a cation part and an ionic part. These may be used alone or in combination.

An amount of the polymerization initiator added may be different depending on a material to be used. The amount of the polymerization initiator is preferably 0.5 parts by mass or more but 10 parts by mass or less, more preferably 1 part by mass or more but 5 parts by mass or less, relative to the total amount of the sealing member (100 parts by mass). When the amount of the polymerization initiator added falls the aforementioned preferable range, curing appropriately proceeds, remaining uncured products can be decreased, and excessive outgas can be prevented.

The drying agent is also called a moisture absorbent and is a material having a function of physically or chemically adsorbing or absorbing moisture. Inclusion of the drying agent in the sealing member can increase moisture resistance and can decrease influence of the outgas.

The drying agent is not particularly limited and may be appropriately selected depending on the intended purpose. However, the drying agent is preferably particulate. Examples of the drying agent include inorganic water-absorbing materials such as calcium oxide, barium oxide, magnesium oxide, magnesium sulfate, sodium sulfate, calcium chloride, silica gel, molecular sieve, and zeolite. Among them, zeolite is preferable because zeolite absorbs a large amount of moisture. These may be used alone or in combination.

The curing accelerator is also called a curing catalyst and is a material that accelerates a curing speed. The curing accelerator is mainly used for a thermosetting epoxy resin.

The curing accelerator is not particularly limited and may be appropriately selected depending on the intended purpose. Examples of the curing accelerator include: tertiary amine or tertiary amine salts such as DBU (1,8-diazabicyclo(5,4,0)-undecene-7) and DBN (1,5-diazabicyclo(4,3,0)-nonene-5); imidazole-based compounds such as 1-cyanoethyl-2-ethyl-4-methylimidazole and 2-ethyl-4-methylimidazole; and phosphine or phosphonium salts such as triphenylphosphine and tetraphenylphosphonium·tetraphenyl borate. These may be used alone or in combination.

The coupling agent is not particularly limited and may be appropriately selected depending on the intended purpose, so long as it is a material having an effect of enhancing a bonding force between molecules. Specific examples of the coupling agent include silane coupling agents. More specific examples of the coupling agent include: silane coupling agents such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, and 3-methacryloxypropyltrimethoxysilane. These may be used alone or in combination.

As the sealing member, epoxy resin compositions that are commercially available as sealing materials, seal materials, or adhesives have been known, and such commercially available products can be effectively used in the present disclosure. Among them, there are also epoxy resin compositions that are developed and are commercially available to be used in solar cells or organic EL elements, and such commercially available products can be particularly effectively used in the present disclosure. Examples of the commercially available epoxy resin compositions include: TB3118, TB3114, TB3124, and TB3125F (available from ThreeBond); World Rock 5910, World Rock 5920, and World Rock 8723 (available from Kyoritsu Chemical Co., Ltd.); and WB90US(P) (available from MORESCO Corporation).

In the present disclosure, a sealing sheet material may be used as the sealing material.

The sealing sheet material is a material where an epoxy resin layer has been formed on a sheet in advance. In the sheet, glass or a film having high gas barrier properties is used. The sealing sheet material and the second substrate can be formed at one time by bonding the sealing sheet material onto the second substrate, followed by curing. A structure having a hollow part can be formed depending on a formation pattern of the epoxy resin layer formed on the sheet.

A method for forming the sealing member is not particularly limited and may be appropriately selected depending on the intended purpose. Examples of the method include a dispensing method, a wire bar method, a spin coating method, a roller coating method, a blade coating method, and a gravure coating method. Moreover, as a method for forming the sealing member, methods such as relief printing, offset printing, gravure printing, intaglio printing, rubber plate printing, and screen printing may be used.

Moreover, a passivation layer may be disposed between the sealing member and the second electrode. The passivation layer is not particularly limited and may be appropriately selected depending on the intended purpose, so long as the passivation layer is disposed in such a manner that the sealing member is not in contact with the second electrode. Examples thereof include aluminum oxide, silicon nitride, and silicon oxide.

Hereinafter, one embodiment of a photoelectric conversion module of the present disclosure will be described with reference to drawings. In each drawing, the same reference numeral is given to the same component, and redundant description may be omitted.

### <Structure of photoelectric conversion module>

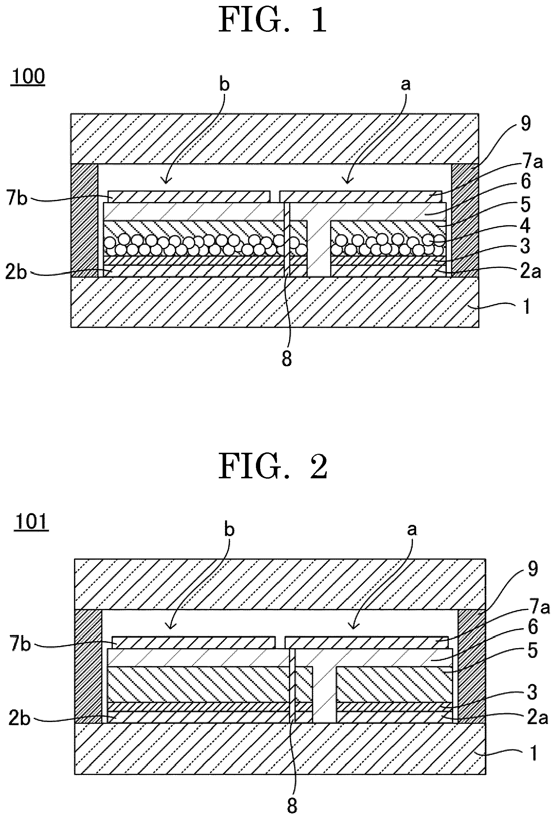

FIG. 1 is an explanatory view presenting one example of a structure in a photoelectric conversion module of the present disclosure.

As presented in FIG. 1, a photoelectric conversion module 100 includes a first substrate 1 and photoelectric conversion elements disposed on the first substrate 1. The photoelectric conversion elements include first electrodes 2a and 2b, compact electron-transporting layers (compact layer) 3, porous electron-transporting layers (porous layer) 4, perovskite layers 5, hole-transporting layers 6, and second electrodes 7a and 7b. Note that, the first electrode 2a or 2b and the second electrode 7a or 7b each include a through part 8 configured to pass current to an electrode extraction terminal.

Moreover, in the photoelectric conversion module 100, the second substrate 10 is disposed so as to face the first substrate 1, so that the first substrate 1 and the second substrate 10 sandwich the photoelectric conversion elements. A sealing member 9 is disposed between the first substrate 1 and the second substrate 10.

In the photoelectric conversion module 100, the first electrode 2a and the first electrode 2b are separated by the hole-transporting layers 6 that are an extended continuous layer.

FIG. 2 is an explanatory view presenting another example of a structure in a photoelectric conversion module of the present disclosure.

As presented in FIG. 2, a photoelectric conversion module 101 is an embodiment where the porous electron-transporting layer (porous layer) 4 does not exist in the photoelectric conversion module 100 presented in FIG. 1.

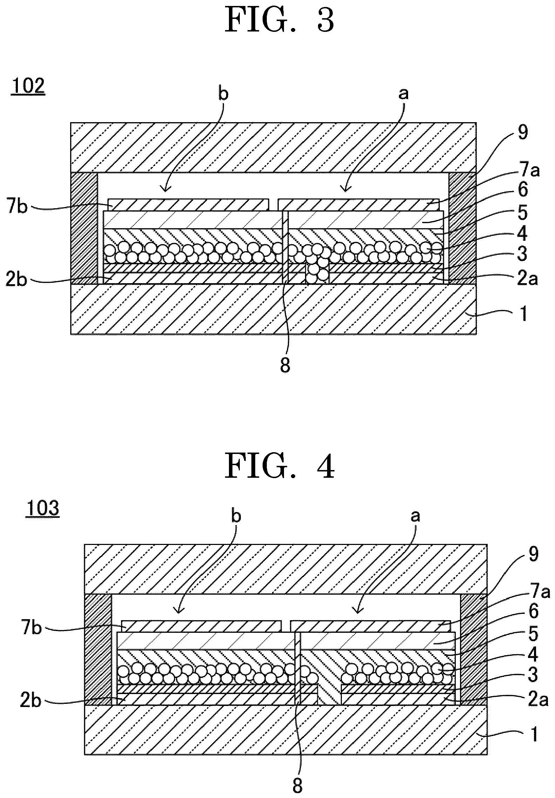

FIG. 3 is an explanatory view presenting another example of a structure in a photoelectric conversion module of the present disclosure.

As presented in FIG. 3, a photoelectric conversion module 102 is an embodiment where not only the hole-transporting layer 6 but also the porous electron-transporting layer (porous layer) 4 and the perovskite layer 5 are extended continuous layers in the photoelectric conversion module 100 presented in FIG. 1.

In the photoelectric conversion module 102, the first electrode 2a and the first electrode 2b are separated by the porous layer 4 and the perovskite layer 5 that are extended continuous layers.

FIG. 4 is an explanatory view presenting another example of a structure in a photoelectric conversion module of the present disclosure.

As presented in FIG. 4, a photoelectric conversion module 103 is an embodiment where the porous layers 4 are not extended in the photoelectric conversion module 102 presented in FIG. 3.

In the photoelectric conversion module 103, the first electrode 2a and the first electrode 2b are separated by the perovskite layer 5 that is an extended continuous layer.

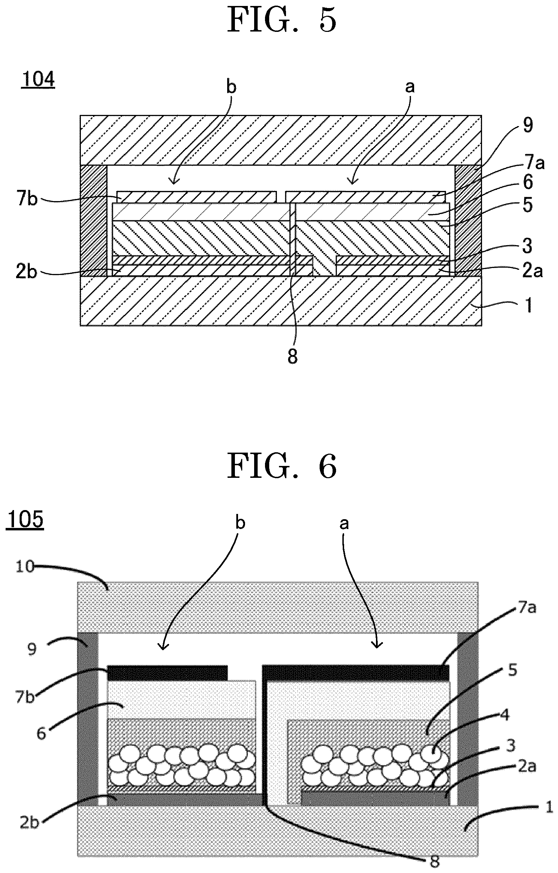

FIG. 5 is an explanatory view presenting another example of a structure in a photoelectric conversion module of the present disclosure.

As presented in FIG. 5, a photoelectric conversion module 104 is an embodiment where the porous layer 4 does not exist in the photoelectric conversion module 103 presented in FIG. 4.

FIG. 6 is an explanatory view presenting another example of a structure in a photoelectric conversion module of the present disclosure.

As presented in FIG. 6, a photoelectric conversion module 105 is an embodiment where each of the perovskite layer 5 and the hole-transporting layer 6 is not extended in the photoelectric conversion module 103 presented in FIG. 4.

In the photoelectric conversion module 105, the first electrode 2a and the first electrode 2b are separated by a hollow wall.

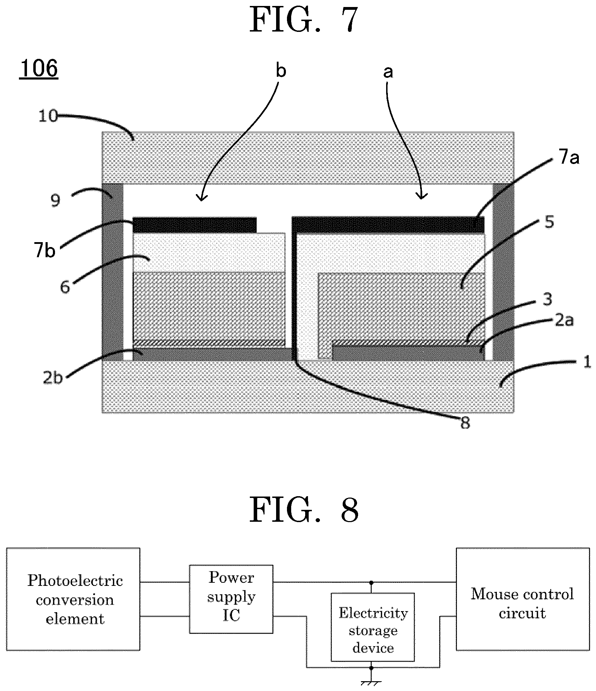

FIG. 7 is an explanatory view presenting another example of a structure in a photoelectric conversion module of the present disclosure.

As presented in FIG. 7, a photoelectric conversion module 106 is an embodiment where the porous layer 4 does not exist in the photoelectric conversion module 105 presented in FIG. 6.

Each of the photoelectric conversion modules 100 to 106 is sealed with the first substrate 1, the sealing member 9, and the second substrate 10. Therefore, it is possible to control an amount of moisture and a concentration of oxygen in a hollow part existing between the second electrode 7 and the second substrate 10. By controlling the amount of moisture and the concentration of oxygen in the hollow part of each of the photoelectric conversion modules 100 to 106, the power generation performance and the durability can be improved. That is, when the photoelectric conversion module further includes: the second substrate that is disposed so as to face the first substrate, so that the first substrate and the second substrate sandwich the photoelectric conversion elements; and the sealing member disposed between the first substrate and the second substrate and seals the photoelectric conversion elements, it is possible to control the amount of moisture and the concentration of oxygen in the hollow part, which can improve the power generation performance and the durability.

The concentration of oxygen in the hollow part is not particularly limited and may be appropriately selected depending on the intended purpose. However, the concentration thereof is preferably 0% or more but 21% or less, more preferably 0.05% or more but 10% or less, still more preferably 0.1% or more but 5% or less.

In each of the photoelectric conversion modules 100 to 106, the second electrode 7 and the second substrate 10 are not in contact with each other. Therefore, it is possible to prevent the second electrode 7 from being exfoliated and broken.

Moreover, each of the photoelectric conversion modules 100 to 106 includes a through part 8 configured to electrically connect the photoelectric conversion element a with the photoelectric conversion element b. In each of the photoelectric conversion modules 100 to 106, the photoelectric conversion element a and the photoelectric conversion element b are connected to each other in series, by electrically connecting the second electrode 7a of the photoelectric conversion element a with the first electrode 2b of the photoelectric conversion element b by the through part 8 penetrating through the hole-transporting layer 6. As described above, when a plurality of photoelectric conversion elements are connected in series, the open-circuit voltage of the photoelectric conversion module can be increased.

Note that, the through part 8 may penetrate through the first electrode 2 to reach the first substrate 1. Alternatively, the through part 8 may not reach the first substrate 1 by stopping the processing inside the first electrode 2. In the case where a shape of the through part 8 is a fine pore that penetrates through the first electrode 2 to reach the first substrate 1, when a total opening area of the fine pore is too large relative to an area of the through part 8, a cross-sectional area of the film of the first electrode 2 is decreased to increase a resistance value, which may decrease photoelectric conversion efficiency. Therefore, a ratio of the total opening area of the fine pore to the area of the through part 8 is preferably 5/100 or more but 60/100 or less.

Moreover, a method for forming the through part is not particularly limited and may be appropriately selected depending on the intended purpose. Examples of the method include a sand blasting method, a water blasting method, a chemical etching method, a laser processing method, and a method using abrasive paper. Among them, the laser processing method is preferable because the fine pore can be formed without using, for example, sand, etching, and resist, and this makes it possible to process the fine pore in clean and reproducible manners. Furthermore, the reason why the laser processing method is preferable is as follows. Specifically, when the through part 8 is formed, it is possible to remove at least one of the compact layer 3, the porous layer 4, the perovskite layer 5, the hole-transporting layer 6, and the second electrode 7 through impact peeling using the laser processing method. Therefore, it is not necessary to provide a mask during lamination, and removal of the materials of which the photoelectric conversion element is formed and formation of the through part can be easily performed at one time.

Here, a space between the perovskite layer in the photoelectric conversion element a and the perovskite layer in the photoelectric conversion element b may be extended or may be separated. When they are separated, a distance therebetween is preferably 1 µm or more but 100 µm or less, more preferably 5 µm or more but 50 µm or less. When the distance between the perovskite layer in the photoelectric conversion element a and the perovskite layer in the photoelectric conversion element b is 1 µm or more but 100 µm or less, the porous titanium oxide layer and the perovskite layer are separated, and less recombination of electrons through diffusion is generated. Therefore, it makes it possible to maintain photoelectric conversion efficiency even after exposure to light having a high illuminance for a long period of time. That is, when a distance between the electron-transporting layer and the perovskite layer in one photoelectric conversion element and the electron-transporting layer and the perovskite layer in the other photoelectric conversion element in at least two photoelectric conversion elements adjacent to each other is 1 µm or more but 100 µm or less, it is possible to maintain photoelectric conversion efficiency even after exposure to light having a high illuminance for a long period of time.

Here, the phrase "distance between the electron-transporting layer and the perovskite layer in one photoelectric conversion element and the electron-transporting layer and the perovskite layer in the other photoelectric conversion element in at least two photoelectric conversion elements adjacent to each other" means the shortest distance among distances between peripheries (end parts) of the electron-transporting layers and the perovskite layers in the photoelectric conversion elements.

The photoelectric conversion module of the present disclosure can be applied to power source devices by using it in combination with, for example, a circuit board configured to control generated electric current. Examples of the devices using such a power source device include electronic desk calculators and watches. In addition, the power source device including the photoelectric conversion element of the present disclosure can be applied to, for example, mobile phones, electronic notebooks, and electronic paper. The power source device including the photoelectric conversion element of the present disclosure can be used as an auxiliary power supply configured to prolong a continuously operating time of rechargeable electrical appliances or dry cell-type electrical appliances, or as a power source that can be used in the nighttime by using it in combination with a secondary cell. Moreover, the photoelectric conversion element of the present disclosure can be used in IoT devices or artificial satellites as self-supporting power supplies that require neither replacement of a cell nor power source wirings.

### (Electronic device)

An electronic device of the present disclosure includes the photoelectric conversion element and/or the photoelectric conversion module of the present disclosure, and a device configured to be driven by electric power generated through photoelectric conversion of the photoelectric conversion element and/or the photoelectric conversion module, and further includes other devices if necessary.

### (Power supply module)

A power supply module of the present disclosure includes the photoelectric conversion element and/or the photoelectric conversion module of the present disclosure and a power supply integrated circuit (IC), and further includes other devices if necessary.

Next, a specific embodiment of an electronic device including the photoelectric conversion element and/or the photoelectric conversion module of the present disclosure, and a device configured to be driven by electric power obtained through power generation of the photoelectric conversion element and/or the photoelectric conversion module will be described.

FIG. 8 is a block diagram of a mouse for a personal computer as one example of an electronic device of the present disclosure.

As presented in FIG. 8, a photoelectric conversion element and/or a photoelectric conversion module, a power supply IC, and an electricity storage device are combined and the supplied electric power is allowed to pass to a power supply of a control circuit of a mouse. As a result, the electricity storage device is charged when the mouse is not used, and the mouse can be driven by the electric power, and therefore such a mouse that requires neither wiring nor replacement of a cell can be obtained. Since a cell is not required, a weight thereof can be decreased, which is effective.

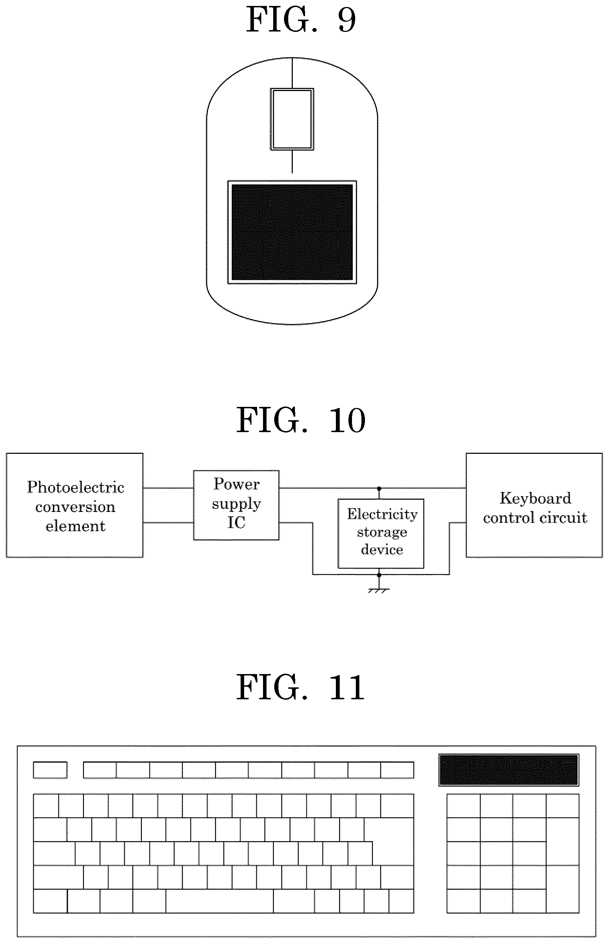

FIG. 9 is a schematic external view presenting one example of the mouse presented in FIG. 8.

As presented in FIG. 9, a photoelectric conversion element, a power supply IC, and an electricity storage device are mounted inside a mouse, but an upper part of the photoelectric conversion element is covered with a transparent housing so that the photoelectric conversion element receives light. Moreover, the whole housing of the mouse can be formed with a transparent resin. The arrangement of the photoelectric conversion element is not limited to the above. For example, the photoelectric conversion element may be arranged in a position to which light is emitted even when the mouse is covered with a hand, and such arrangement may be preferable.

Next, another embodiment of an electronic device including the photoelectric conversion element and/or the photoelectric conversion module of the present disclosure, and a device configured to be driven by electric power obtained through power generation of the photoelectric conversion element and/or the photoelectric conversion module will be described.

FIG. 10 is a block diagram of a keyboard for a personal computer as one example of an electronic device of the present disclosure.

As presented in FIG. 10, a photoelectric conversion element, a power supply IC, and an electricity storage device are combined, and the supplied electric power is allowed to pass to a power supply of a control circuit of a keyboard. As a result, the electricity storage device is charged when the keyboard is not used, and the keyboard can be driven by the electric power. Therefore, such a keyboard that requires neither wiring nor replacement of a cell can be obtained. Since a cell is not required, a weight thereof can be decreased, which is effective.

FIG. 11 is a schematic external view presenting one example of the keyboard presented in FIG. 10.

As presented in FIG. 11, a photoelectric conversion element, a power supply IC, and an electricity storage device are mounted inside the keyboard, but an upper part of the photoelectric conversion element is covered with a transparent housing so that the photoelectric conversion element receives light. The whole housing of the keyboard can be formed of a transparent resin. The arrangement of the photoelectric conversion element is not limited to the above.

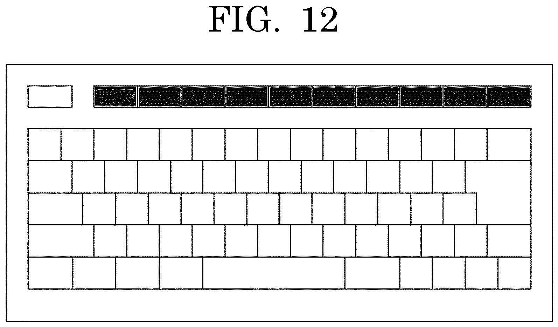

In the case of a small keyboard in which a space for incorporating the photoelectric conversion element is small, a small photoelectric conversion element may be embedded in some keys as presented in FIG. 12, and such arrangement is effective.

Next, another embodiment of an electronic device including the photoelectric conversion element and/or the photoelectric conversion module of the present disclosure, and a device configured to be driven by electric power obtained through power generation of the photoelectric conversion element and/or the photoelectric conversion module will be described.

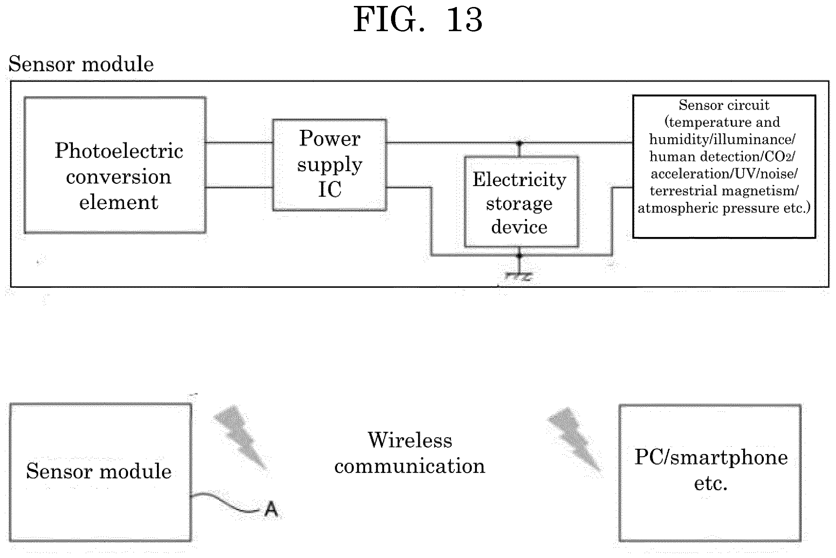

FIG. 13 is a block diagram of a sensor as one example of an electronic device of the present disclosure.

As presented in FIG. 13, a photoelectric conversion element, a power supply IC, and an electricity storage device are combined, and the supplied electric power is allowed to pass to a power supply of a control circuit of a sensor circuit. As a result, a sensor module can be constituted without requiring connection to an external power supply and without requiring replacement of a cell. A sensing target is, for example, temperature and humidity, illuminance, human detection, CO₂, acceleration, UV, noise, terrestrial magnetism, and atmospheric pressure, and such an electronic device can be applied to various sensors, which is effective. As presented in A in FIG. 13, the sensor module is configured to sense a target to be measured on a regular basis and to transmit the read data to, for example, a personal computer (PC) or a smartphone through wireless communication.

It is expected that use of sensors is significantly increased as the Internet of Things (IoT) society approaches. Replacing cells of numerous sensors one by one is time consuming and is not realistic. Moreover, the fact that a sensor is installed at a position such as a celling and a wall where a cell is not easily replaced also makes workability bad. The fact that electricity can be supplied by the photoelectric conversion element is also significantly advantageous. In addition, the photoelectric conversion element of the present disclosure has advantages that a high output can be obtained even with light of low illuminance and a high degree of freedom in installation can be achieved because dependence of light incident angle for the output is small.

Next, another embodiment of an electronic device including the photoelectric conversion element and/or the photoelectric conversion module of the present disclosure and a device configured to be driven by electric power obtained through power generation of the photoelectric conversion element and/or the photoelectric conversion module will be described.

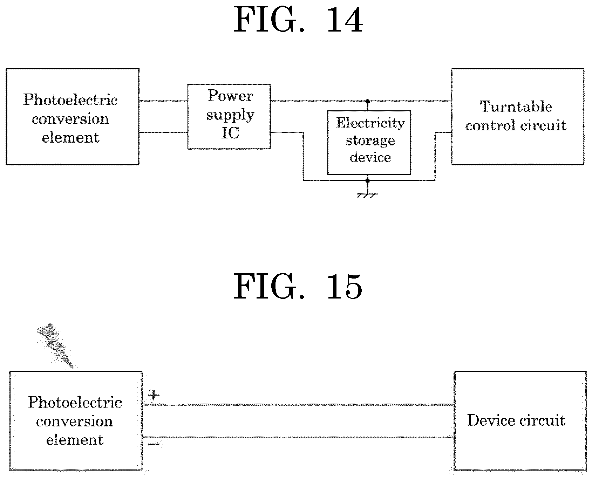

FIG. 14 is a block diagram of a turntable as one example of an electronic device of the present disclosure.

As presented in FIG. 14, the photoelectric conversion element, a power supply IC, and an electricity storage device are combined, and the supplied electric power is allowed to pass to a power supply of a turntable control circuit. As a result, a turntable can be constituted without requiring connection to an external power supply and without requiring replacement of a cell.

The turntable is used, for example, in a display case in which products are displayed. Wiring of a power supply degrades appearance of the display, and moreover displayed products need to be removed at the time of replacing a cell, which is time-consuming. Use of the photoelectric conversion element of the present disclosure is effective because the aforementioned problems can be solved.

### <Use>

As described above, the electronic device including the photoelectric conversion element and/or the photoelectric conversion module of the present disclosure and the device configured to be driven by electric power obtained through power generation of the photoelectric conversion element and/or the photoelectric conversion module, and the power supply module have been described above. However, the embodiments described above are only part of applicable embodiments, and use of the photoelectric conversion element or the photoelectric conversion module of the present disclosure is not limited to the above-described uses.

The photoelectric conversion element and/or the photoelectric conversion module can be applied for, for example, a power supply device by combining it with a circuit board configured to control generated electric current.

Examples of devices using the power supply device include electronic desk calculators, watches, mobile phones, electronic organizers, and electronic paper.

Moreover, a power supply device including the photoelectric conversion element can be used as an auxiliary power supply for prolonging a continuous operating time of a rechargeable or dry cell-type electronic equipment.

The photoelectric conversion element and the photoelectric conversion module of the present disclosure can function as a self-sustaining power supply, and electric power generated through photoelectric conversion can be used to drive a device. Since the photoelectric conversion element and the photoelectric conversion module of the present disclosure can generate electricity by irradiation of light, neither connection of the electronic device to a power supply nor replacement of a cell is required. Therefore, the electronic device can be driven in a place where there is no power supply facility, the electronic device can be worn or carried, and the electronic device can be driven without replacement of a cell even in a place where a cell is not easily replaced. Moreover, when a dry cell is used, the electronic device becomes heavy by a weight of the dry cell, or the electronic device becomes large by a size of the dry cell. Therefore, there may be a problem in installing the electronic device on a wall or celling, or transporting the electronic device. Since the photoelectric conversion element and the photoelectric conversion module of the present disclosure are light and thin, they can be freely installed, and can be worn and carried, which is advantageous.

As described above, the photoelectric conversion element and the photoelectric conversion module of the present disclosure can be used as a self-sustaining power supply, and can be combined with various electronic devices. For example, the photoelectric conversion element and the photoelectric conversion module of the present disclosure can be used in combination with a display device (e.g., an electronic desk calculator, a watch, a mobile phone, an electronic organizer, and electronic paper), an accessory device of a personal computer (e.g., a mouse and a keyboard), various sensor devices (e.g., a temperature and humidity sensor and a human detection sensor), transmitters (e.g., a beacon and a global positioning system (GPS)), and numerous electronic devices (e.g., auxiliary lamps and remote controllers).

The photoelectric conversion element and the photoelectric conversion module of the present disclosure are widely applied because they can generate electricity particularly with light of low illuminance and can generate electricity indoors and in further darker shade. Moreover, the photoelectric conversion element and the photoelectric conversion module are highly safe because liquid leakage found in the case of a dry cell does not occur, and accidental ingestion found in the case of a button cell does not occur. Furthermore, the photoelectric conversion element and the photoelectric conversion module can be used as an auxiliary power supply for the purpose of prolonging a continuous operation time of a rechargeable or dry cell-type electronic equipment. As described above, when the photoelectric conversion element and the photoelectric conversion module of the present disclosure are combined with a device configured to be driven by electric power generated through photoelectric conversion of the photoelectric conversion element and/or the photoelectric conversion module, it is possible to obtain an electronic device that is light and easy to use, has a high degree of freedom in installation, does not require replacement of a cell, is excellent in safety, and is effective in decreasing environmental loads.

FIG. 15 presents a block diagram presenting one example of an electronic device of the present disclosure obtained by combining the photoelectric conversion element and/or the photoelectric conversion module of the present disclosure with a device configured to be driven by electric power generated through photoelectric conversion of the photoelectric conversion element and/or the photoelectric conversion module. The electronic device can generate electricity when the photoelectric conversion element is irradiated with light, and can extract electric power. A circuit of the device can be driven by the generated electric power.

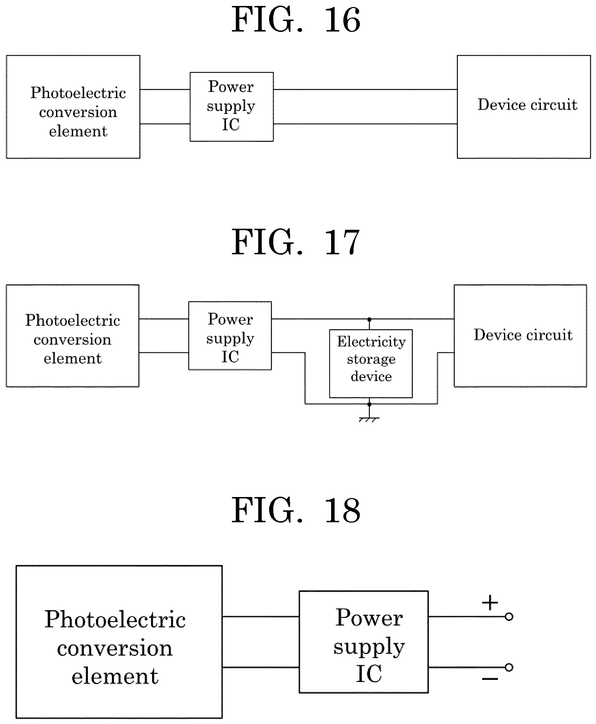

Since the output of the photoelectric conversion element varies depending on circumferential illuminance, the electronic device presented in FIG. 15 may not be stably driven in some cases. In this case, as presented in FIG. 16, a power supply IC for a photoelectric conversion element can be incorporated between the photoelectric conversion element and the circuit of the device in order to supply stable voltage to a side of the circuit, and such arrangement is effective.

The photoelectric conversion element can generate electricity so long as light of sufficient illuminance is emitted. However, when illuminance for generating electricity is not enough, desired electric power cannot be obtained, which is a disadvantage of the photoelectric conversion element. In this case, as presented in FIG. 17, when an electricity storage device such as a capacitor is mounted between a power supply IC and a device circuit, excess electric power from the photoelectric conversion element can be stored in the electricity storage device. In addition, the electric power stored in the electricity storage device can be supplied to the device circuit to thereby enable stable operation when the illuminance is too low or even when the photoelectric conversion element does not receive light.

As described above, the electronic device obtained by combining the photoelectric conversion element and/or the photoelectric conversion module of the present disclosure with the device circuit can be driven even in an environment without a power supply, does not require replacement of a cell and can be stably driven, in combination with a power supply IC or an electricity storage device. Therefore, it is possible to make the most of advantages of the photoelectric conversion element.

Meanwhile, the photoelectric conversion element and/or the photoelectric conversion module of the present disclosure can also be used as a power supply module, and such use is effective. As presented in FIG. 18, for example, when the photoelectric conversion element and/or the photoelectric conversion module of the present disclosure is(are) coupled to a power supply IC for a photoelectric conversion element, a DC power supply module, which can supply electric power generated through photoelectric conversion of the photoelectric conversion element to the power supply IC at a predetermined voltage level, can be constituted.

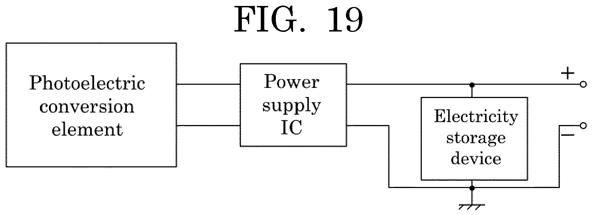

Moreover, as presented in FIG. 19, when an electricity storage device is added to a power supply IC, electric power generated by the photoelectric conversion element can be stored in the electricity storage device. Therefore, a power supply module that can supply electric power can be constituted when the illuminance is too low or even when the photoelectric conversion element does not receive light.

The power supply modules of the present disclosure presented in FIG. 18 and FIG. 19 can be used as a power supply module without replacement of a cell as in case of primary cells known in the art.

### Examples

Hereinafter, the present disclosure will be described by way of Examples and Comparative Examples. However, the present disclosure should not be construed as being limited to the Examples exemplified herein.

### (Synthesis Example 1)

### <Synthesis of compound represented by General Formula (3)>

A compound (B-11) represented by the following structural formula was synthesized under the following reaction.

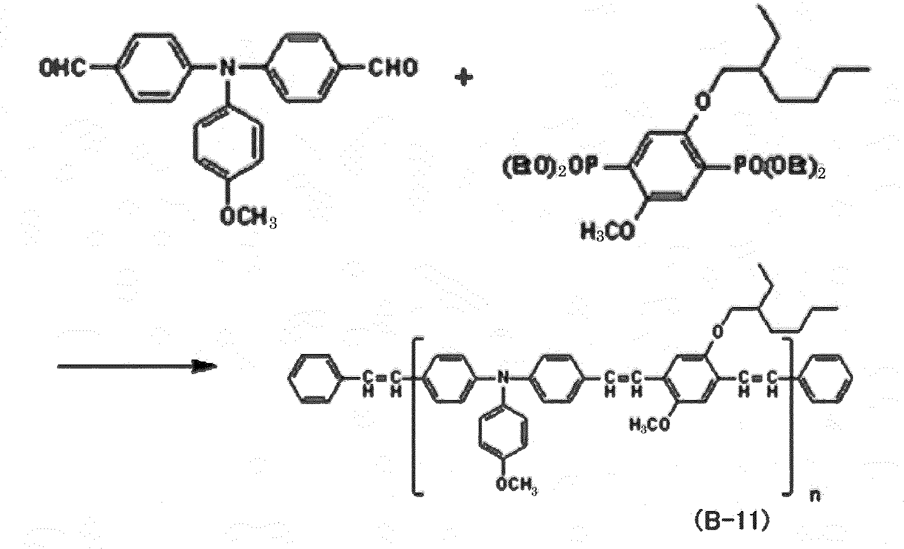

Here, n is an integer that is 2 or more and allows the polymer (B-11) to have a weight average molecular weight of 2,000 or more.

Specifically, a 100 mL-four-neck-flask was charged with the above dialdehyde compound (0.66 g, 2.0 mmol) and a diphosphonate compound (1.02 g, 2.0 mmol), and was purged with nitrogen, followed by addition of tetrahydrofuran (75 mL). To the resultant solution, a 1.0 mol/dm³ tetrahydrofuran solution of potassium t-butoxide (6.75 mL, 6.75 mmol) was added dropwise, followed by stirring at room temperature for 2 hours. Then, diethyl benzylphosphonate and benzaldehyde were added in this order, followed by stirring for 2 hours. Acetic acid (about 1 mL) was added thereto to complete the reaction, and the solution was washed with water. After the solvent was removed under reduced pressure, and purification was performed through reprecipitation using tetrahydrofuran and methanol, to obtain a compound (B-11) (0.95 g) expressed by the above structural formula.

The obtained compound (B-11) expressed by the above structural formula was found to have a weight average molecular weight of 20,000 in terms of polystyrene, where the weight average molecular weight was measured through gel filtration chromatography (GPC). An ionization potential of the compound (B-11), which was measured using an electronic spectroscopic device (AC-2, obtained from RIKEN KEIKI Co., Ltd.), was 5.22 eV. Hereinafter, all the ionization potentials were measured using AC-2.

### (Example 1)

### <Production of photoelectric conversion element>

First, a solution obtained by dissolving a titanium diisopropoxide bis(acetylacetone) isopropyl alcohol solution (75%) (0.36 g) in isopropyl alcohol (10 mL) was coated on an FTO glass substrate (first substrate and first electrode) by the spin coating method, followed by drying at 120°C for 3 minutes. Then, the resultant was baked at 450°C for 30 minutes, to form a compact electron-transporting layer (compact layer) on the FTO glass substrate.

An average thickness of the compact layer was adjusted so as to be 10 µm or more but 40 µm or less.

Next, a dispersion liquid obtained by diluting titanium oxide paste (MPT-20, obtained from Greatcell Solar Limited) with α-terpineol was coated on the compact layer by the spin coating method, and was dried at 120°C for 3 minutes, followed by baking at 550°C for 30 minutes. Subsequently, a solution of acetonitrile (0.1 M, where M means mol/dm³) obtained by dissolving lithium bis(trifluoromethanesulfonyl)imide (38103, obtained from KANTO CHEMICAL CO., INC.) was coated on the aforementioned film by the spin coating method, and was baked at 450°C for 30 minutes, to form a porous electron-transporting layer (porous layer).

An average thickness of the porous layer was adjusted so as to be 100 nm or more but 150 nm or less.

Next, lead(II) iodide (0.5306 g), lead(II) bromide (0.0736 g), methylamine bromide (0.0224 g), formamidine hydroiodide (0.1876 g), and potassium iodide (0.0112 g) were added to N,N-dimethylformamide (0.8 mL) and dimethyl sulfoxide (0.2 mL), and the resultant was heated and stirred at 60°C, to obtain a solution. The solution was coated on the aforementioned porous layer by the spin coating method while chlorobenzene (0.3 mL) was added thereto, to form a perovskite film. Then, the perovskite film was dried at 150°C for 30 minutes to form a perovskite layer.

An average thickness of the perovskite layer was adjusted so as to be 200 nm or more but 350 nm or less.

Then, the compound (B-11) expressed by the above structural formula (weight average molecular weight = 20,000, ionization potential: 5.22 eV) (36.8 mg), 2,2(7,7(-tetrakis-(N,N-di-p-methoxyphenylamine)9,9(-spirobifluorene))) (hereinafter, referred to as "spiro-OMeTAD", obtained from Merck, molecular weight = 1,225.4, ionization potential = 5.09 eV) (36.8 mg), the compound (A-58) expressed by the following structural formula (4.9 mg), 4-t-butylpyridine (6.8 mg), and tris(2-(1H-pyrazol-1-yl)-4-tert-butylpyridine) cobalt(III) hexafluorophosphate (0.1 mg) were dissolved in chlorobenzene (1.5 mL), to obtain a solution. The obtained solution was coated on the laminated product obtained through the aforementioned steps by the spin coating method, to obtain a hole-transporting layer.

An average thickness of the hole-transporting layer (a part on the perovskite layer) was adjusted so as to be 100 nm or more but 200 nm or less. A difference between ionization potentials of the two kinds of hole-transporting materials was 0.13 eV.

Moreover, gold (obtained from TANAKA Kikinzoku Kogyo K.K.) (100 nm) was deposited on the aforementioned laminated product under vacuum, to obtain a photoelectric conversion element 1.

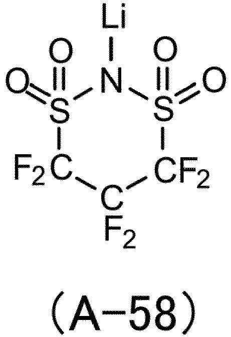

The obtained photoelectric conversion element 1 was evaluated for solar cell characteristics (initial characteristics) using a solar cell evaluation system (As-510-PV03, obtained from NF CORPORATION) while light was emitted thereto using a solar simulator (AM 1.5, 100 mW/cm²). Moreover, the photoelectric conversion element 1 was continuously irradiated with light using the aforementioned solar simulator for 500 hours under the same conditions as those described above, and was evaluated for solar cell characteristics (characteristics obtained after continuous irradiation for 500 hours) in the same manner as described above.

The items of the evaluated solar cell characteristics were open circuit voltage, short circuit current density, shape factor, and conversion efficiency (photoelectric conversion efficiency). A rate of the conversion efficiency obtained after continuous irradiation for 500 hours relative to the conversion efficiency in the initial characteristics was determined as a maintenance rate of the conversion efficiency. Results are presented in Table 1.

### (Example 2)

A photoelectric conversion element 2 was produced and evaluated in the same manner as in Example 1 except that the compound (A-58) expressed by the structural formula was changed to the compound (A-59) expressed by the following structural formula. Results are presented in Table 1.

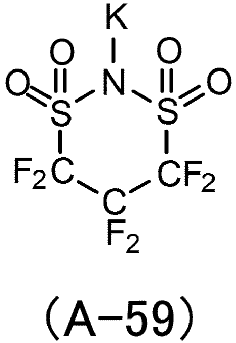

### (Example 3)

A photoelectric conversion element 3 was produced and evaluated in the same manner as in Example 1 except that the compound (B-11) expressed by the aforementioned structural formula (weight average molecular weight = 20,000, ionization potential: 5.22 eV) (36.8 mg) was changed to the compound (C-1) (hereinafter, referred to as "P3HT", weight average molecular weight = 50,000, ionization potential = 5.0 eV) expressed by the following structural formula; and spiro-OMeTAD (molecular weight = 1,225.4, ionization potential = 5.09 eV) (36.8 mg) was changed to the compound (A-2) (molecular weight: 554.9, ionization potential = 5.05 eV) expressed by the following structural formula. Results are presented in Table 1.

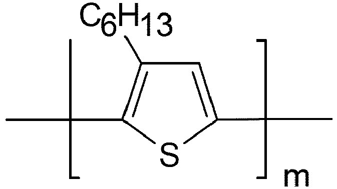

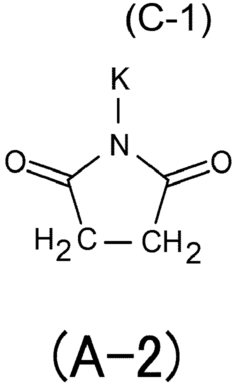

### (Example 4)

A photoelectric conversion element 4 was produced and evaluated in the same manner as in Example 1 except that the compound (A-58) expressed by the aforementioned structural formula was changed to the compound (A-73) expressed by the following structural formula. Results are presented in Table 1.

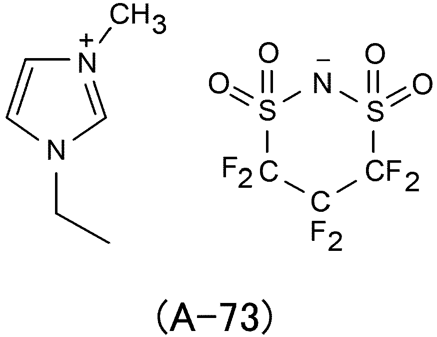

### (Example 5)

A photoelectric conversion element 5 was produced and evaluated in the same manner as in Example 1 except that the compound (A-58) expressed by the aforementioned structural formula was changed to the compound (A-75) expressed by the following structural formula. Results are presented in Table 1.

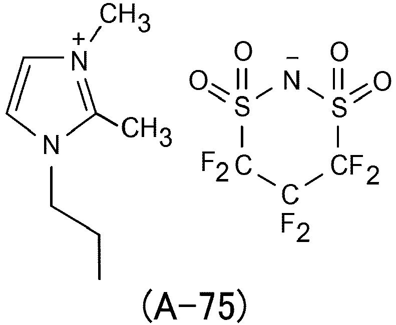

### (Example 6)

A photoelectric conversion element 6 was produced and evaluated in the same manner as in Example 1 except that the compound (B-11) expressed by the aforementioned structural formula (weight average molecular weight = 20,000, ionization potential: 5.22 eV) (36.8 mg) and spiro-OMeTAD (molecular weight = 1,225.4, ionization potential = 5.09 eV) (36.8 mg) were changed to spiro-OMeTAD (73.6 mg). Results are presented in Table 1.

### (Comparative Example 1)

A photoelectric conversion element 7 was produced and evaluated in the same manner as in Example 1 except that the compound (A-58) expressed by the aforementioned structural formula was changed to lithium bis(trifluoromethanesulfonyl)imide. Results are presented in Table 1.

### (Comparative Example 2)

A photoelectric conversion element 8 was produced and evaluated in the same manner as in Example 1 except that the compound (A-58) expressed by the aforementioned structural formula was changed to potassium bis(trifluoromethanesulfonyl)imide. Results are presented in Table 1.

### (Comparative Example 3)

A photoelectric conversion element 9 was produced and evaluated in the same manner as in Example 1 except that the compound (A-58) expressed by the aforementioned structural formula was changed to lithium bis (fluorosulfonyl)imide. Results are presented in Table 1.

**Table 1**

| | Photoelectric conversion element | Initial characteristics | | | | Characteristics obtained after continuous irradiation for 500 hours | | | | Maintenance rate of conversion efficiency (%) |
|---|---|---|---|---|---|---|---|---|---|---|
| | | Open circuit voltage (V) | Short circuit current density (mA/cm²) | Shape factor | Conversion efficiency (%) | Open circuit voltage (V) | Short circuit current density (mA/cm²) | Shape factor | Conversion efficiency (%) | |
| Ex. 1 | 1 | 1.09 | 20.04 | 0.66 | 14.41 | 1.083 | 19.86 | 0.66 | 14.2 | 98.5 |
| Ex. 2 | 2 | 1.088 | 19.99 | 0.67 | 14.57 | 1.08 | 19.93 | 0.66 | 14.21 | 97.5 |
| Ex. 3 | 3 | 1.034 | 20.07 | 0.65 | 13.49 | 1.031 | 20.03 | 0.65 | 13.42 | 99.5 |
| Ex. 4 | 4 | 1.104 | 18.87 | 0.66 | 13.75 | 1.084 | 18.62 | 0.66 | 13.32 | 96.9 |
| Ex. 5 | 5 | 1.108 | 18.49 | 0.66 | 13.52 | 1.091 | 18.09 | 0.66 | 13.03 | 96.4 |
| Ex. 6 | 6 | 1.112 | 20.09 | 0.65 | 14.63 | 1.102 | 17.84 | 0.65 | 12.78 | 87.4 |
| Comp. Ex. 1 | 7 | 1.069 | 20.01 | 0.67 | 14.33 | 0.932 | 16.24 | 0.63 | 9.54 | 66.6 |
| Comp. Ex. 2 | 8 | 1.093 | 19.94 | 0.66 | 14.38 | 0.897 | 15.79 | 0.62 | 8.78 | 61.1 |
| Comp. Ex. 3 | 9 | 1.088 | 19.89 | 0.65 | 14.07 | 0.733 | 15.49 | 0.62 | 7.04 | 50 |

It is found from the results of Table 1 that not only the initial characteristics good but also the maintenance rate of conversion efficiencies are high in Examples 1 to 6, in which the hole-transporting layer include the compound represented by the aforementioned General Formula (1) or (1a). Particularly, Examples 1 to 3, in which the hole-transporting layer includes the compound of a metal (e.g., lithium or potassium) salt, each exhibit a high maintenance rate of conversion efficiency. Examples 4 and 5, in which the hole-transporting layer includes a compound of an organic cation, each exhibit a high maintenance rate of conversion efficiency. On the other hand, it is found that Comparative Examples 1 to 3, in which the hole-transporting layer includes no compound represented by the aforementioned General Formula (1) or (1a), exhibit a high conversion efficiency in the initial characteristics, but exhibit a decrease in the conversion efficiency after exposure to light of high illuminance for a long period of time; and have a low maintenance rate of conversion efficiency.

As described above, when the hole-transporting layer includes a compound represented by the General Formula (1) or (1a), the photoelectric conversion element of the present disclosure can maintain the photoelectric conversion efficiency even after exposure to light of high illuminance for a long period of time.

Example 6, in which the hole-transporting layer includes no compound represented by General Formula (3) or General Formula (4), has a slightly lower maintenance rate of conversion efficiency, compared to Examples 1 to 5 in which the hole-transporting layer includes a compound represented by General Formula (3) or General Formula (4). Therefore, it is found that not only inclusion of a compound represented by General Formula (1) or (1a) but also inclusion of a compound represented by General Formula (3) or (4) can achieve higher performance.

A photoelectric conversion module obtained by coupling the photoelectric conversion elements in series was produced and evaluated. Examples 7 to 13 in connection with the photoelectric conversion module will be described below.

### (Example 7)

### <Production of photoelectric conversion module>

First, a solution obtained by dissolving titanium diisopropoxide bis(acetylacetone) isopropyl alcohol solution (75%) (0.36 g) in isopropyl alcohol (10 ml) was coated on an FTO glass substrate by the spin coating method, followed by drying at 120°C for 3 minutes. Then, the resultant was baked at 450°C for 30 minutes, to form a compact electron-transporting layer (compact layer) on the FTO glass substrate.

An average thickness of the compact layer was adjusted so as to be 10 µm or more but 40 µm or less.

Next, a dispersion liquid obtained by diluting titanium oxide paste (MPT-20, obtained from Greatcell Solar Limited) with α-terpineol was coated on the compact layer by the spin coating method, and was dried at 120°C for 3 minutes, followed by baking at 550°C for 30 minutes. Subsequently, a solution of acetonitrile (0.1 M) obtained by dissolving lithium bis(trifluoromethanesulfonyl)imide (38103, obtained from KANTO CHEMICAL CO., INC.) was coated on the aforementioned film by the spin coating method, and was baked at 450°C for 30 minutes, to form a porous electron-transporting layer (porous layer).

An average thickness of the porous layer was adjusted so as to be 100 nm or more but 150 nm or less.

Next, lead(II) iodide (0.5306 g), lead(II) bromide (0.0736 g), methylamine bromide (0.0224 g), formamidine hydroiodide (0.1876 g), and potassium iodide (0.0112 g) were added to N,N-dimethylformamide (0.8 mL) and dimethyl sulfoxide (0.2 mL), and the resultant was heated and stirred at 60°C, to obtain a solution. The solution was coated on the aforementioned porous layer by the spin coating method while chlorobenzene (0.3 mL) was added thereto, to form a perovskite film. Then, the perovskite film was dried at 150°C for 30 minutes to form a perovskite layer.

An average thickness of the perovskite layer was adjusted so as to be 200 nm or more but 350 nm or less.

The laminated product obtained through the aforementioned steps was subjected to laser processing to form a groove so that a distance between the laminated products adjacent to each other would be 10 µm.

Then, the compound (B-11) expressed by the above structural formula (weight average molecular weight = 20,000, ionization potential: 5.22 eV) (36.8 mg), spiro-OMeTAD (molecular weight = 1,225.4, ionization potential = 5.09 eV) (36.8 mg), the compound (A-58) expressed by the aforementioned structural formula (4.9 mg), 4-t-butylpyridine (6.8 mg), and tris(2-(1H-pyrazol-1-yl)-4-tert-butylpyridine) cobalt(III) hexafluorophosphate (0.1 mg) were dissolved in chlorobenzene (1.5 mL), to obtain a solution. The obtained solution was coated on the laminated product obtained through the aforementioned steps by the spin coating method, to obtain a hole-transporting layer.

An average thickness of the hole-transporting layer (a part on the perovskite layer) was adjusted so as to be 100 nm or more but 200 nm or less. A difference between ionization potentials of the two kinds of hole-transporting materials was 0.13 eV.

Moreover, gold (100 nm) was deposited on the aforementioned laminated product under vacuum.

Then, ends of the FTO glass substrate and a cover glass as the second substrate, where the sealing member would be disposed, were subjected to an etching treatment through laser processing. Moreover, a through hole (conduction section) configured to couple the photoelectric conversion elements in series was formed through laser processing. Then, silver was deposited on the laminated product under vacuum to form a second electrode having an average thickness of about 100 nm. By film formation using a mask, a distance between the second electrodes adjacent to each other was adjusted so as to be 200 µm. It was confirmed that gold was deposited on the inner walls of the through hole and the photoelectric conversion elements adjacent to each other were coupled in series. Note that, the number of the photoelectric conversion elements coupled in series was set to 6.

Then, a dispenser (2300N, obtained from SAN-EI TECH Ltd.) was used to coat an ultraviolet curing resin (TB3118, obtained from ThreeBond Co., Ltd.) as the sealing member on the ends of the FTO glass substrate that had been subjected to laser processing so that the photoelectric conversion elements (power generation region) would be surrounded. Then, it was transferred to a glove box where the low humidity (dew point: -30°C) was maintained and the oxygen concentration was controlled to 0.2%, and the cover glass that had been subjected to laser processing was placed on the ultraviolet curing resin. The ultraviolet curing resin was cured by irradiation of ultraviolet rays, and the power generation region was sealed, to produce a photoelectric conversion module 1 having a structure presented in FIG. 1. The photoelectric conversion module 1 was evaluated in the same manner as in Example 1. Results are presented in Table 2. Note that, two photoelectric conversion elements are coupled in series in FIG. 1, but six photoelectric conversion elements were coupled in series in the present Example.

### (Example 8)

A photoelectric conversion module 2 having a structure presented in FIG. 2 was produced in the same manner as in Example 7 except that the porous layer was not formed. The photoelectric conversion module 2 was evaluated in the same manner as in Example 1. Results are presented in Table 2.

### (Example 9)

A photoelectric conversion module 3 having a structure presented in FIG. 3 was produced in the same manner as in Example 7 except that the porous layer and the perovskite layer were each an extended continuous layer. The photoelectric conversion module 3 was evaluated in the same manner as in Example 1. Results are presented in Table 2.

### (Example 10)

A photoelectric conversion module 4 having a structure presented in FIG. 4 was produced in the same manner as in Example 7 except that a difference between the first electrodes, a difference between the compact layers, and a difference between the porous layers in the photoelectric conversion elements adjacent to each other were changed to 40 µm; and the perovskite layer was an extended continuous layer. The photoelectric conversion module 4 was evaluated in the same manner as in Example 1. Results are presented in Table 2.

### (Example 11)

A photoelectric conversion module 5 having a structure presented in FIG. 5 was produced in the same manner as in Example 10 except that the porous layer was not formed. The photoelectric conversion module 5 was evaluated in the same manner as in Example 1. Results are presented in Table 2.

### (Example 12)

A photoelectric conversion module 6 having a structure presented in FIG. 6 was produced in the same manner as in Example 7 except that a difference between the first electrodes, a difference between the compact layers, a difference between the porous layers, a difference between the perovskite layers, and a difference between the hole-transporting layers in the photoelectric conversion elements adjacent to each other were changed to 40 µm; and the second electrode 7a in the photoelectric conversion element a and the first electrode 2b in the photoelectric conversion element b were directly joined. The photoelectric conversion module 6 was evaluated in the same manner as in Example 1. Results are presented in Table 2.

### (Example 13)

A photoelectric conversion module 7 having a structure presented in FIG. 7 was produced in the same manner as in Example 12 except that the porous layer was not formed. The photoelectric conversion module 7 was evaluated in the same manner as in Example 1. Results are presented in Table 2.

**Table 2**

| | Photoelectric conversion module | Initial characteristics | | | | Characteristics obtained after continuous irradiation for 500 hours | | | | Maintenance rate of conversion efficiency (%) |
|---|---|---|---|---|---|---|---|---|---|---|
| | | Open circuit voltage (V) | Short circuit current density (mA/cm²) | Shape factor | Conversion efficiency (%) | Open circuit voltage (V) | Short circuit current density (mA/cm²) | Shape factor | Conversion efficiency (%) | |
| Ex. 7 | 1 | 6.34 | 3.26 | 0.67 | 13.85 | 6.33 | 3.25 | 0.66 | 13.58 | 98.1 |
| Ex. 8 | 2 | 6.32 | 3.31 | 0.66 | 13.81 | 6.28 | 3.29 | 0.65 | 13.43 | 97.2 |
| Ex. 9 | 3 | 6.29 | 3.28 | 0.64 | 13.2 | 6.24 | 3.27 | 0.63 | 12.86 | 97.4 |
| Ex. 10 | 4 | 6.23 | 3.16 | 0.63 | 12.4 | 6.21 | 3.14 | 0.62 | 12.09 | 97.5 |
| Ex. 11 | 5 | 6.27 | 3.22 | 0.62 | 12.52 | 6.22 | 3.18 | 0.61 | 12.07 | 96.4 |
| Ex. 12 | 6 | 6.61 | 3.07 | 0.67 | 13.6 | 6.58 | 3.05 | 0.65 | 13.04 | 95.9 |
| Ex. 13 | 7 | 6.58 | 3.09 | 0.67 | 13.62 | 6.53 | 3.06 | 0.65 | 12.99 | 95.4 |

It is found that from the results of Table 2 that all the photoelectric conversion modules in Examples 7 to 13 obtained good conversion efficiency. Among them, it is found that the photoelectric conversion modules in Examples 7, 8, 12, and 13 obtained better conversion efficiency, and such a structure that the perovskite layer was not extended was good because good conversion efficiency could be obtained.

As described above, the photoelectric conversion element of the present disclosure includes the hole-transporting layer that includes a compound represented by the General Formula (1) or the General Formula (1a) in the photoelectric conversion element including the first electrode, the electron-transporting layer, the perovskite layer, the hole-transporting layer, and the second electrode. This makes it possible for the photoelectric conversion element of the present disclosure to maintain photoelectric conversion efficiency even after exposure to light of high illuminance for a long period of time.

## Claims

1. A photoelectric conversion element comprising:
a first electrode (2a, 2b);
a perovskite layer (5);
a hole-transporting layer (6); and
a second electrode (7a, 7b),
wherein the hole-transporting layer (6) includes a compound represented by General Formula (1) below or General Formula (1a) below: 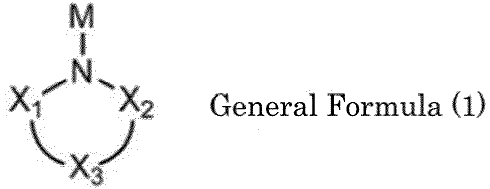
where, in the General Formula (1), M represents an alkali metal; X₁ and X₂, which may be identical to or different from each other, each represent at least one selected from the group consisting of a carbonyl group, a sulphonyl group, and a sulfinyl group; and X₃ represents at least one selected from the group consisting of a bivalent alkyl group, an alkenyl group, and an aryl group, and a hydrogen atom of the bivalent alkyl group, the alkenyl group, and the aryl group may be substituted with a halogen atom; 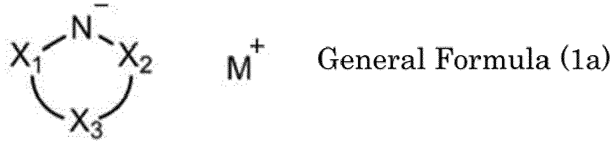
where, in the General Formula (1a), M⁺ represents an organic cation; and X₁, X₂, and X₃ have same meanings as X₁, X₂, and X₃ in the General Formula (1).

2. The photoelectric conversion element according to claim 1,
wherein the compound represented by the General Formula (1) is a compound represented by General Formula (2) below, and the compound represented by the General Formula (1a) is a compound represented by General Formula (2a) below: 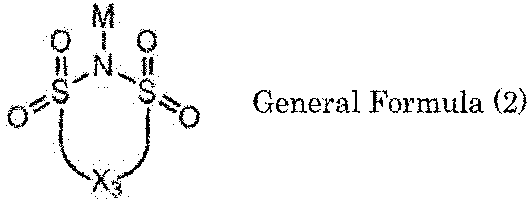 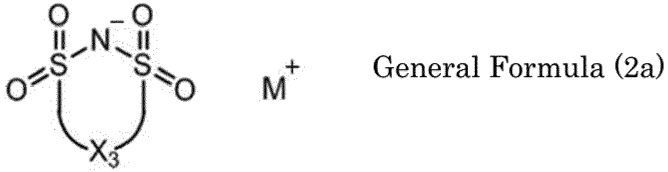
where, in the General Formula (2) and the General Formula (2a), X₃, M, and M⁺ have same meanings as X₃, M, and M⁺ in the General Formula (1) and the General Formula (1a).

3. The photoelectric conversion element according to claim 2,
wherein, in the General Formula (2), M represents lithium; and X₃ is a bivalent alkyl group having from 2 through 4 carbon atoms that may include a fluorine atom as a substituent.

4. The photoelectric conversion element according to claim 2,
wherein, in the General Formula (2a), the organic cation represented by M⁺ is expressed by a structural formula below:

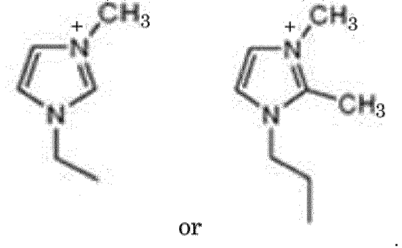

5. The photoelectric conversion element according to any one of claims 1 to 4,
wherein the hole-transporting layer (6) includes a polymer including a recurring unit represented by General Formula (3) below or General Formula (4) below: 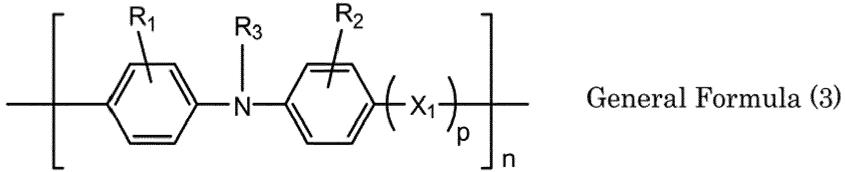
where, in the General Formula (3), R₁ and R₂, which may be identical to or different from each other, each represent at least one selected from the group consisting of a hydrogen atom, an alkyl group, an aralkyl group, an alkoxy group, and an aryl group; R₃ represents one selected from the group consisting of an alkyl group, an aralkyl group, an aryl group, and a heterocyclic group; X₁ represents one selected from the group consisting of an alkylene group, an alkenyl group, an alkynyl group, an aryl group, and a heterocyclic group; n is an integer that is 2 or more and allows the polymer represented by the General Formula (3) to have a weight average molecular weight of 2,000 or more; and p is 0, 1, or 2; 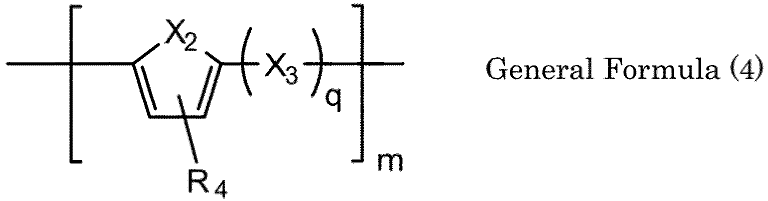
where, in the General Formula (4), R₄ represents one selected from the group consisting of a hydrogen atom, an alkyl group, an aralkyl group, an alkoxy group, and an aryl group; X₂ represents one selected from the group consisting of an oxygen atom, a sulfur atom, and a selenium atom; X₃ represents one selected from the group consisting of an alkenyl group, an alkynyl group, an aryl group, and a heterocyclic group; m is an integer that is 2 or more and allows the polymer represented by the General Formula (4) to have a weight average molecular weight of 2,000 or more; and q is 0, 1, or 2.

6. The photoelectric conversion element according to any one of claims 1 to 5,
wherein the perovskite layer (5) includes at least one selected from the group consisting of an alkali metal and an antimony atom.

7. A photoelectric conversion module comprising
photoelectric conversion elements coupled in series or in parallel, each of the photoelectric conversion elements being the photoelectric conversion element according to any one of claims 1 to 6.

8. The photoelectric conversion module according to claim 7,
wherein, in at least two of the photoelectric conversion elements adjacent to each other, the hole-transporting layers (6) are extended continuous layers, and at least two of the first electrodes (2a, 2b) adjacent to each other and at least two of the perovskite layers (5) adjacent to each other are separated by the hole-transporting layers (6).

9. The photoelectric conversion module according to claim 7 or 8,
wherein, in at least two of the photoelectric conversion elements adjacent to each other, the first electrode in one photoelectric conversion element and the second electrode in other photoelectric conversion element are electrically coupled through a conduction section (8) penetrating through the hole-transporting layers (6) that are extended continuous layers.

10. An electronic device comprising:
the photoelectric conversion element according to any one of claims 1 to 6, the photoelectric conversion module according to any one of claims 7 to 9, or both; and
a device configured to be driven by electric power generated through photoelectric conversion of the photoelectric conversion element, the photoelectric conversion module, or both.

11. A power supply module comprising:
the photoelectric conversion element according to any one of claims 1 to 6, the photoelectric conversion module according to any one of claims 7 to 9, or both; and
a power supply integrated circuit (IC).

12. An electronic device comprising:
the power supply module according to claim 11; and
an electricity storage device.

## Patentansprüche

1. Photoelektrisches Wandlerelement, das Folgendes umfasst:
eine erste Elektrode (2a, 2b);
eine Perowskit-Schicht (5);
eine Lochtransportschicht (6); und
eine zweite Elektrode (7a, 7b),
wobei die Lochtransportschicht (6) eine Verbindung enthält, die durch die folgende allgemeine Formel (1) oder die folgende allgemeine Formel (1a) dargestellt wird: 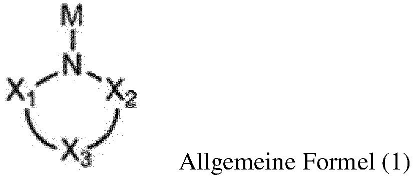
wobei in der allgemeinen Formel (1) M ein Alkalimetall darstellt; X₁ und X₂, die identisch oder voneinander verschieden sein können, jeweils mindestens eine Gruppe, ausgewählt aus der Gruppe bestehend aus einer Carbonylgruppe, einer Sulfonylgruppe und einer Sulfinylgruppe, darstellen; und X₃ mindestens eine Gruppe darstellt, ausgewählt aus der Gruppe bestehend aus einer bivalenten Alkylgruppe, einer Alkenylgruppe und einer Arylgruppe, und ein Wasserstoffatom der bivalenten Alkylgruppe, der Alkenylgruppe und der Arylgruppe kann mit einem Halogenatom substituiert sein; 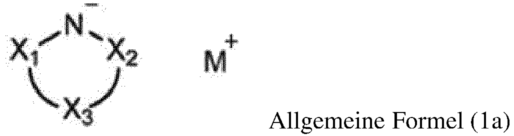
wobei in der allgemeinen Formel (1a) M⁺ ein organisches Kation darstellt; und X₁, X₂ und X₃ die gleichen Bedeutungen haben wie X₁, X₂ und X₃ in der allgemeinen Formel (1).

2. Photoelektrisches Wandlerelement nach Anspruch 1,
wobei die durch die allgemeine Formel (1) dargestellte Verbindung eine durch die nachstehende allgemeine Formel (2) dargestellte Verbindung ist, und die durch die allgemeine Formel (1a) dargestellte Verbindung eine durch die nachstehende allgemeine Formel (2a) dargestellte Verbindung ist: 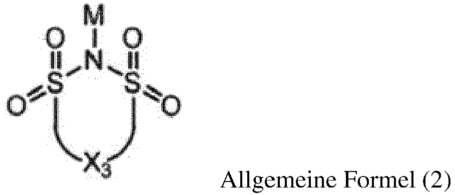 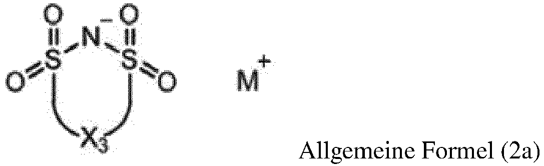 wobei in der allgemeinen Formel (2) und der allgemeinen Formel (2a) X₃, M und M⁺ dieselben Bedeutungen haben wie X₃, M und M⁺ in der allgemeinen Formel (1) und der allgemeinen Formel (1a).

3. Photoelektrisches Wandlerelement nach Anspruch 2,
wobei in der allgemeinen Formel (2) M Lithium darstellt; und X₃ eine zweiwertige Alkylgruppe mit 2 bis 4 Kohlenstoffatomen ist, die ein Fluoratom als Substituent enthalten kann.

4. Photoelektrisches Wandlerelement nach Anspruch 2,
wobei in der allgemeinen Formel (2a) das durch M⁺ dargestellte organische Kation durch die nachstehende Strukturformel ausgedrückt ist:

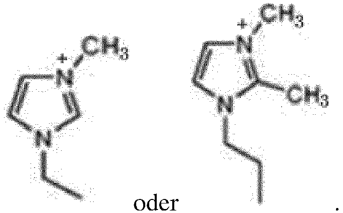

5. Photoelektrisches Wandlerelement nach einem der Ansprüche 1 bis 4,
wobei die Lochtransportschicht (6) ein Polymer enthält, das eine wiederkehrende Einheit enthält, die durch die nachstehende allgemeine Formel (3) oder die nachstehende allgemeine Formel (4) dargestellt wird: 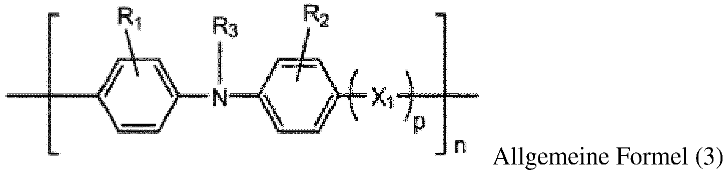
wobei in der allgemeinen Formel (3) R₁ und R₂, die identisch oder voneinander verschieden sein können, jeweils mindestens eine Gruppe, ausgewählt aus der Gruppe bestehend aus einem Wasserstoffatom, einer Alkylgruppe, einer Aralkylgruppe, einer Alkoxygruppe und einer Arylgruppe, darstellen; R₃ eine Gruppe darstellt, die aus der Gruppe ausgewählt ist bestehend aus einer Alkylgruppe, einer Aralkylgruppe, einer Arylgruppe und einer heterocyclischen Gruppe; X₁ eine Gruppe darstellt, die aus der Gruppe ausgewählt ist bestehend aus einer Alkylengruppe, einer Alkenylgruppe, einer Alkynylgruppe, einer Arylgruppe und einer heterocyclischen Gruppe; n eine ganze Zahl ist, die 2 oder mehr ist und dem durch die allgemeine Formel (3) dargestellten Polymer ermöglicht, ein gewichtsmittleres Molekulargewicht von 2.000 oder mehr aufzuweisen; und p 0, 1 oder 2 ist, 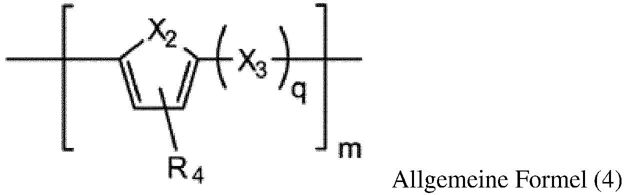
wobei in der allgemeinen Formel (4) R₄ eines, ausgewählt aus der Gruppe bestehend aus einem Wasserstoffatom, einer Alkylgruppe, einer Aralkylgruppe, einer Alkoxygruppe und einer Arylgruppe, darstellt; X₂ eines, ausgewählt aus der Gruppe bestehend aus einem Sauerstoffatom, einem Schwefelatom und einem Selenatom darstellt; X₃ eines, ausgewählt aus der Gruppe bestehend aus einer Alkenylgruppe, einer Alkinylgruppe, einer Arylgruppe und einer heterocyclischen Gruppe darstellt; m eine ganze Zahl ist, die 2 oder mehr ist und dem durch die allgemeine Formel (4) dargestellten Polymer ermöglicht, ein gewichtsmittleres Molekulargewicht von 2.000 oder mehr aufzuweisen; und q 0, 1 oder 2 ist.

6. Photoelektrisches Wandlerelement nach einem der Ansprüche 1 bis 5,
wobei die Perowskit-Schicht (5) mindestens ein aus der Gruppe ausgewähltes Element enthält, die aus einem Alkalimetall und einem Antimonatom besteht.

7. Photoelektrisches Wandlermodul, das Folgendes umfasst:
in Reihe oder parallel geschaltete photoelektrische Wandlerelemente, wobei jedes der photoelektrischen Wandlerelemente das photoelektrische Wandlerelement nach einem der Ansprüche 1 bis 6 ist.

8. Photoelektrisches Wandlermodul nach Anspruch 7,
wobei in mindestens zwei der photoelektrischen Wandlerelemente, die einander benachbart sind, die Lochtransportschichten (6) ausgedehnte kontinuierliche Schichten sind, und mindestens zwei der ersten Elektroden (2a, 2b), die einander benachbart sind, und mindestens zwei der Perowskit-Schichten (5), die einander benachbart sind, durch die Lochtransportschichten (6) getrennt sind.

9. Photoelektrisches Wandlermodul nach Anspruch 7 oder 8,
wobei in mindestens zwei der einander benachbarten photoelektrischen Wandlerelemente die erste Elektrode in dem einen photoelektrischen Wandlerelement und die zweite Elektrode in dem anderen photoelektrischen Wandlerelement über einen Leitungsabschnitt (8) elektrisch gekoppelt sind, der durch die Lochtransportschichten (6), die ausgedehnte durchgehende Schichten sind, hindurchgeht.

10. Elektronische Vorrichtung, die Folgendes umfasst:
das photoelektrische Wandlerelement nach einem der Ansprüche 1 bis 6, das photoelektrische Wandlermodul nach einem der Ansprüche 7 bis 9 oder beide; und
eine Vorrichtung, die dafür konfiguriert ist, durch elektrische Energie betrieben zu werden, die durch photoelektrische Umwandlung des photoelektrischen Wandlerelements, des photoelektrischen Wandlermoduls oder beider erzeugt wird.

11. Stromversorgungsmodul, das Folgendes umfasst:
das photoelektrische Wandlerelement nach einem der Ansprüche 1 bis 6, das photoelektrische Wandlermodul nach einem der Ansprüche 7 bis 9 oder beide; und
eine integrierte Schaltung (Integrated Circuit, IC) zur Stromversorgung.

12. Elektronische Vorrichtung, die Folgendes umfasst:
das Stromversorgungsmodul nach Anspruch 11 und
eine Elektrizitätsspeichervorrichtung.

## Revendications

1. Elément de conversion photoélectrique comprenant :
une première électrode (2a, 2b) ;
un couche de pérovskite (5) ;
une couche de transport de trous (6) ; et
une deuxième électrode (7a, 7b),
dans lequel la couche de transport de trous (6) comprend un composé représenté par la formule générale (1) ci-dessous ou la formule générale (1a) ci-dessous : 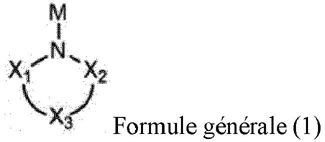
où, dans la formule générale (1), M représente un métal alcalin ; X₁ et X₂, qui peuvent être identiques ou différents l'un de l'autre, représentent chacun au moins un élément choisi dans le groupe constitué par un groupe carbonyle, un groupe sulfonyle et un groupe sulfinyle ; et X₃ représente au moins un élément choisi dans le groupe constitué par un groupe alkyle bivalent, un groupe alcényle et un groupe aryle, et un atome d'hydrogène du groupe alkyle bivalent, le groupe alcényle et le groupe aryle peuvent être substitués par un atome d'halogène ; 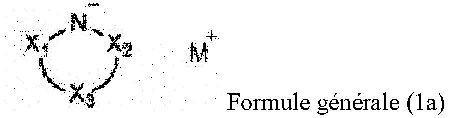
où, dans la formule générale (1a), M⁺ représente un cation organique ; et X₁, X₂ et X₃ ont les mêmes significations que X₁, X₂ et X₃ dans la formule générale (1).

2. Elément de conversion photoélectrique selon la revendication 1,
dans lequel le composé représenté par la formule générale (1) est un composé représenté par la formule générale (2) ci-dessous, et le composé représenté par la formule générale (1a) est un composé représenté par la formule générale (2a) ci-dessous : 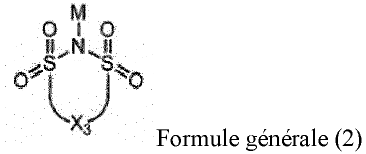 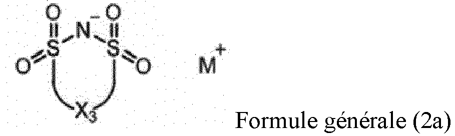
où, dans la formule générale (2) et la formule générale (2a), X₃, M et M⁺ ont les mêmes significations que X₃, M et M⁺ dans la formule générale (1) et la formule générale (1a).

3. Elément de conversion photoélectrique selon la revendication 2,
dans lequel, dans la formule générale (2), M représente le lithium ; et X₃ est un groupe alkyle bivalent ayant de 2 à 4 atomes de carbone qui peut comprendre un atome de fluor comme substituant.

4. Elément de conversion photoélectrique selon la revendication 2,
dans lequel, dans la formule générale (2a), le cation organique représenté par M⁺ est exprimé par une formule structurale ci-dessous :

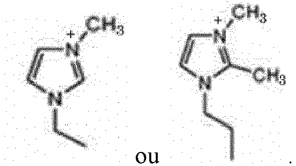

5. Elément de conversion photoélectrique selon l'une quelconque des revendications 1 à 4, dans lequel la couche de transport de trous (6) comprend un polymère comprenant une unité récurrente représentée par la formule générale (3) ci-dessous ou la formule générale (4) ci-dessous : 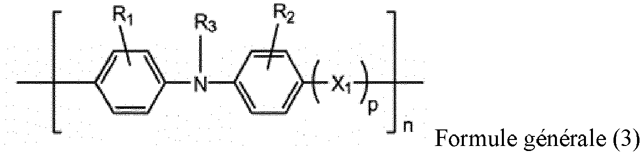
où, dans la formule générale (3), R₁ et R₂, qui peuvent être identiques ou différents l'un de l'autre, représentent chacun au moins un élément choisi dans le groupe constitué par un atome d'hydrogène, un groupe alkyle, un groupe aralkyle, un groupe alcoxy et un groupe aryle ; R₃ représente un groupe choisi dans le groupe constitué par un groupe alkyle, un groupe aralkyle, un groupe aryle et un groupe hétérocyclique ; X₁ représente un élément choisi dans le groupe constitué par un groupe alkylène, un groupe alcényle, un groupe alcynyle, un groupe aryle et un groupe hétérocyclique ; n est un nombre entier qui vaut 2 ou plus et permet au polymère représenté par la formule générale (3) d'avoir un poids moléculaire moyen en poids de 2000 ou plus ; et p vaut 0, 1 ou 2; 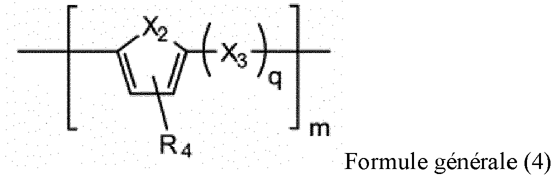
où, dans la formule générale (4), R₄ représente un élément choisi dans le groupe constitué par un atome d'hydrogène, un groupe alkyle, un groupe aralkyle, un groupe alcoxy et un groupe aryle ; X₂ représente un élément choisi dans le groupe constitué par un atome d'oxygène, un atome de soufre et un atome de sélénium ; X₃ représente un élément choisi dans le groupe constitué par un groupe alcényle, un groupe alcynyle, un groupe aryle et un groupe hétérocyclique ; m est un nombre entier qui vaut 2 ou plus et permet au polymère représenté par la formule générale (4) d'avoir un poids moléculaire moyen en poids de 2000 ou plus ; et q vaut 0, 1 ou 2.

6. Elément de conversion photoélectrique selon l'une quelconque des revendications 1 à 5, dans lequel la couche de pérovskite (5) comprend au moins un élément choisi dans le groupe constitué par un métal alcalin et un atome d'antimoine.

7. Module de conversion photoélectrique comprenant
des éléments de conversion photoélectrique couplés en série ou en parallèle, chacun des éléments de conversion photoélectrique étant l'élément de conversion photoélectrique selon l'une quelconque des revendications 1 à 6.

8. Module de conversion photoélectrique selon la revendication 7,
dans lequel, dans au moins deux des éléments de conversion photoélectrique adjacents l'un à l'autre, les couches de transport de trous (6) sont des couches continues étendues, et au moins deux des premières électrodes (2a, 2b) adjacentes l'une à l'autre et au moins deux des couches de pérovskite (5) adjacentes l'une à l'autre sont séparées par les couches de transport de trous (6).

9. Module de conversion photoélectrique selon la revendication 7 ou 8,
dans lequel, dans au moins deux des éléments de conversion photoélectrique adjacents l'un à l'autre, la première électrode dans un élément de conversion photoélectrique et la deuxième électrode dans un autre élément de conversion photoélectrique sont couplées électriquement par une section de conduction (8) pénétrant à travers les couches de transport de trous (6) qui sont des couches continues étendues.

10. Dispositif électronique comprenant :
l'élément de conversion photoélectrique selon l'une quelconque des revendications 1 à 6, le module de conversion photoélectrique selon l'une quelconque des revendications 7 à 9, ou les deux ; et
un dispositif configuré pour être entraîné par une énergie électrique générée par conversion photoélectrique de l'élément de conversion photoélectrique, du module de conversion photoélectrique ou des deux.

11. Module d'alimentation comprenant :
l'élément de conversion photoélectrique selon l'une quelconque des revendications 1 à 6, le module de conversion photoélectrique selon l'une quelconque des revendications 7 à 9, ou les deux ; et
un circuit intégré d'alimentation (IC).

12. Dispositif électronique comprenant :
le module d'alimentation selon la revendication 11 ; et
un dispositif de stockage d'électricité.
